# EUROPÄISCHE PATENTSCHRIFT

(11) **EP 4 108 497 B1**
(45) Veröffentlichungstag und Bekanntmachung des Hinweises auf die Patenterteilung: **07.08.2024**
(21) Anmeldenummer: 22179295.5
(22) Anmeldetag: 15.06.2022
(51) Int. Cl.: H01H 11/00, H01H 47/00, B60L 3/00, G01R 31/327, H01H 9/56

(54) **VERFAHREN ZUM LADEN EINES ELEKTROFAHRZEUGS UNTER VERWENDUNG EINER SICHERHEITSSCHALTUNG**
METHOD FOR CHARGING AN ELECTRIC VEHICLE USING A SAFETY CIRCUIT
PROCÉDÉ DE CHARGE D'UN VÉHICULE ÉLECTRIQUE À L'AIDE D'UN CIRCUIT DE SÉCURITÉ

(30) Priorität: 18.06.2021 DE 102021115882
(43) Veröffentlichungstag der Anmeldung: 28.12.2022
(73) Patentinhaber: Lade GmbH, 55129 Mainz (DE)
(72) Erfinder: SCHULMEYER, Dennis, 55129 Mainz (DE)
(74) Vertreter: Richardt Patentanwälte PartG mbB

(56) Entgegenhaltungen:
- EP-A2- 2 500 208
- DE-A1- 102005 051 762
- DE-A1- 102018 104 916
- DE-B3- 102018 102 503

## Beschreibung

Die Erfindung betrifft ein Verfahren zum Laden eines Elektrofahrzeugs, ein System zum Laden eines Elektrofahrzeugs, sowie ein Computerprogrammprodukt.

Die Elektromobilität erfordert eine flächendeckende Versorgung mit Ladesäulen, an welchen Elektrofahrzeuge elektrisch aufgeladen werden können. Elektrofahrzeuge können PKWs, LKWs, Fahrräder, Elektroroller und vieles mehr sein. Um bei einem Laden des Elektrofahrzeugs an einer der Ladesäulen eine Gefahr von Kurzschlussströmen oder Fehlströmen zu reduzieren, können Relais oder Schütze in Phasenleitern der Ladesäule vorgesehen sein.

Die DE 10 2016 216 321 A1 beschreibt ein Verfahren zum Schalten eines Stroms mit einer Schaltvorrichtung, welche Bestandteil einer Ladevorrichtung für Elektrofahrzeuge sein kann. Die Schaltvorrichtung weist einen Schalter in zumindest einem Phasenleiter und eine Steuervorrichtung zum Öffnen oder Schließen des Schalters auf. Die Steuervorrichtung ist dafür eingerichtet, nach Maßgabe des Zeitpunktes eines Nulldurchgangs eines in dem Phasenleiter fließenden Stroms ein Schließen des Schalters zu veranlassen. Eine Schaltung des Schalters während des Nulldurchgangs könnte eine Belastung des Schalters im Fall eines Kurzschlusses reduzieren.

Der Erfindung liegt die Aufgabe zugrunde, ein verbessertes Verfahren zum Laden eines Elektrofahrzeugs, ein entsprechendes System und ein Computerprogrammprodukt zu schaffen. Die der Erfindung zugrunde liegenden Aufgaben werden durch die Merkmale der unabhängigen Patentansprüche gelöst. Bevorzugte Ausführungsformen der Erfindung sind in den abhängigen Patentansprüchen angegeben.

Es wird ein Verfahren zum Laden eines Elektrofahrzeugs an einem Ladepunkt unter Verwendung einer Sicherheitsschaltung vorgeschlagen. Die Sicherheitsschaltung weist einen versorgungsnetzseitigen Eingangsanschluss, einen elektrofahrzeugseitigen Ausgangsanschluss, ein Schütz und ein Relais auf. Das Relais ist mit dem Ausgangsanschluss verbunden und über einen Schaltkontakt des Schützes mit dem Eingangsanschluss verbunden. Bei geschlossenem Schaltkontakt des Schützes kann Strom von dem Eingangsanschluss über das Schütz durch das Relais hin zum Ausgangsanschluss fließen. Ist das Schütz geöffnet, kann kein Strom von dem Schütz durch das Relais fließen. Das Relais weist im Vergleich zu dem Schütz eine kürzere Nennschaltzeit auf. Das Relais weist einen ersten Lastkontakt und einen zweiten Lastkontakt auf. Ist das Relais geschlossen, ist der erste Lastkontakt mit dem zweiten Lastkontakt leitend verbunden. Im geöffneten Zustand des Relais kann kein Strom zwischen dem ersten und dem zweiten Lastkontakt fließen. Ein Öffnen und Schließen des Relais kann durch ein Ansteuern zumindest eines Steuerkontaktes des Relais bewirkt werden.

Unter der Nennschaltzeit des Relais und des Schützes wird eine von einem Hersteller angegebene Zeit zum Umschalten des Relais beziehungsweise des Schützes verstanden. Bevorzugt ist die Nennschaltzeit des Schützes etwa mindestens fünf bis zehn Mal so hoch wie die Nennschaltzeit des Relais.

Das vorgeschlagene Verfahren weist durch die Sicherheitsschaltung als Reaktion auf einen Empfang eines Steuersignals zum Laden des Elektrofahrzeugs bei geöffnetem Schaltkontakt des Schützes ein Durchführen eines Testvorgangs und eines Ladevorgangs auf. Bevorzugt weist die Sicherheitsschaltung zum Durchführen des Testvorgangs und des Ladevorgangs eine Steuereinheit auf. Praktischerweise ist die Steuereinheit ausgebildet, das Steuersignal zum Laden zu empfangen und den Testvorgang in Abhängigkeit des Steuersignals zum Laden zu initiieren.

Der Testvorgang umfasst ein Anlegen einer ersten Testspannung an das geöffnete oder geschlossene Relais, ein Auslösen eines Schließens oder Öffnens des Relais bei angelegter erster Testspannung und ein Messen der durch das Relais geschalteten ersten Testspannung oder einer Stromstärke eines aufgrund der ersten Testspannung durch das Relais fließenden ersten Teststroms während des Schließens oder Öffnens des Relais. Beispielsweise kann ein nicht linearer erster Teststrom von ca. 200µA bis 500pA hinter dem Relais gemessen werden. Dabei kann die erste Testspannung in Form einer Spannung an einer Testspannungsquelle gemessen werden. Die Testspannungsquelle hat bevorzugt einen Eigenwiderstand von 1k bis 100kOhm. Mithilfe einer geeichten Zählereinrichtung kann der erste Teststrom und die erste Testspannung gemessen werden.

Die erste Testspannung kann beispielsweise an dem ersten Lastkontakt des Relais angelegt werden. An dem zweiten Lastkontakt kann die erste Testspannung oder die Stromstärke des Teststroms gemessen werden. Das Öffnen oder Schließen des Relais kann durch das Ansteuern des Steuerkontaktes des Relais ausgelöst werden, beispielsweise in Form eines Sendens eines Steuersignals zum Schalten des Relais zu dem Steuerkontakt. Die erste Testspannung ist bevorzugt um ein Vielfaches niedriger als, beispielsweise nur halb oder ein Viertel so hoch wie, eine Ladespannung zum Laden des Elektrofahrzeugs. Dadurch könnte vermieden werden, dass das Relais beim Durchführen des Testvorgangs z.B. aufgrund einer Lichtbogenbildung beschädigt wird. Die erste Testspannung kann zum Schaltungsschutz hochohmig und abgesichert angeschlossen und hochohmig abgegriffen werden. Dies kann einerseits zum Personenschutz dienen, falls ein Fehler in einer Isolation vorliegt. Andererseits kann dadurch einen Defekt detektiert werden, bei dem die volle Netzspannung auf einem zu testenden Leitungsabschnitt liegt.

Weiterhin umfasst der Testvorgang ein Ermitteln einer aktuellen Schaltzeit des Relais durch Auswertung der ersten Testspannung oder der Stromstärke des ersten Teststroms. Die Auswertung kann eine erste Prüfung umfassen, ob die erste Testspannung oder die Stromstärke des Teststroms sinkt oder nahezu gleich Null ist, für den Fall, dass das Relais bei dem Testvorgang geöffnet wird. Für den Fall, dass das Relais bei dem Testvorgang geschlossen wird, kann die Auswertung eine zweite Prüfung umfassen, ob die erste Testspannung an dem zweiten Lastkontakt anliegt oder die Stromstärke an dem zweiten Lastkontakt steigt. Die erste und zweite Prüfung kann jeweils ein Abtasten der ersten Testspannung oder Stromstärke an dem zweiten Lastkontakt mithilfe einer Messschaltung vorsehen.

Die aktuelle Schaltzeit ist die Zeit, die zwischen dem Auslösen des Öffnens oder Schließens des Relais bis zu einem erfolgten Öffnens beziehungsweise Schließens des Relais vergeht. Das Öffnen kann als erfolgt betrachtet werden, sobald die erste Testspannung oder die Stromstärke des Teststroms nahezu gleich Null oder gleich Null ist. Das Schließen kann als erfolgt betrachtet werden, sobald die erste Testspannung an dem zweiten Lastkontakt anliegt oder die Stromstärke an dem zweiten Lastkontakt steigt.

Der Ladevorgang weist ein Schließen des Relais auf, falls das Relais bei der Messung der Stromstärke des ersten Teststroms geöffnet wurde.

Weiterhin weist der Ladevorgang ein Laden des Elektrofahrzeugs mit einem Ladestrom durch Schließen des Schaltkontakts des Schützes nach dem Schließen des Relais auf. Der Ladevorgang umfasst weiterhin ein Messen eines zeitlichen Verlaufs der Spannung und / oder der Stromstärke des Ladestroms während des Ladevorgangs. Im Rahmen dieser Offenbarung wird davon ausgegangen, dass mit dem Laden des Elektrofahrzeugs mit dem Ladestrom eine Versorgung des Eingangsanschlusses mit dem Ladestrom und auch einer Spannung einhergeht. Im Folgenden wird diese Spannung als Spannung des Ladestroms bezeichnet. Im Allgemeinen ist der Ladestrom als Wechselstrom ausgebildet. Dadurch wird an dem Eingangsanschluss und an dem Ausgangsanschluss und in Leitungsabschnitten zwischen dem Eingangsanschluss und dem Ausgangsanschluss die Spannung und die Stromstärke des Ladestroms zeitlich variieren, z.B. mit einer Netzfrequenz von z.B. 50 Hz oder 60 Hz. Insbesondere ist die Spannung des Ladestroms gegenüber der Stromstärke des Ladestroms nicht phasengleich, sondern weist eine Phasenverschiebung auf. Des Weiteren kann die Stromstärke des Ladestroms in einigen Abschnitten einen Verlauf aufweisen, der von einem sinusförmigen Verlauf abweicht.

Das vorgeschlagene Verfahren umfasst als Reaktion auf einen Empfang eines Steuersignals zur Schnellabschaltung des Ladevorgangs ein Durchführen eines Abschaltvorgangs. Der Abschaltvorgang umfasst ein Bestimmen eines gewünschten Schaltzeitpunkts des Relais basierend auf dem gemessenen zeitlichen Verlauf der Stromstärke und / oder der Spannung des Ladestroms. Weiterhin umfasst der Abschaltvorgang ein Auslösen eines Öffnens des Relais zu einem Schaltauslösezeitpunkt. Zum Schaltauslösezeitpunkt entspricht die verbleibende Zeit bis zum gewünschten Schaltzeitpunkt einem auf der aktuellen Schaltzeit basierenden Vorschaltintervall. Das Öffnen des Relais wird beispielsweise durch das Senden des Steuersignals zum Schalten des Relais zu dem Steuerkontakt des Relais ausgelöst.

Bevorzugt wird das Vorschaltintervall zumindest in Abhängigkeit der aktuellen Schaltzeit ermittelt. Weiterhin wird bevorzugt ein zukünftiger Nulldurchgang des zeitlichen Verlaufes der Stromstärke in Abhängigkeit des gemessenen zeitlichen Verlaufes der Stromstärke und / oder der Spannung des Ladestroms ermittelt. Ist beispielsweise die Phasenverschiebung zwischen der Stromstärke und der Spannung des Ladestroms bekannt, kann der zukünftige Nulldurchgang des zeitlichen Verlaufes der Stromstärke in Abhängigkeit des gemessenen zeitlichen Verlaufes der Spannung des Ladestroms bestimmt werden. Möglich ist, dass während des Ladevorgangs die Phasenverschiebung erfasst wird. Die Phasenverschiebung kann unter Umständen von dem zu ladenden Elektrofahrzeug abhängen.

Der Abschaltvorgang umfasst weiterhin ein Öffnen des Schaltkontakts des Schützes. Dadurch könnte eine Sicherheit der Sicherheitsschaltung weiter erhöht werden. Dies ist dadurch begründet, dass eine elektrische Verbindung zwischen dem Eingangsanschluss und dem Ausgangsanschluss bei geöffnetem Schütz und geöffnetem Relais zweifach unterbrochen ist. Der Schaltkontakt des Schützes wird z.B. spätestens innerhalb von 40 Millisekunden nach dem Auslösen des Öffnens des Relais geöffnet. Des Weiteren kann durch ein Messen eines aktuellen Wertes der Spannung oder der Stromstärke des Ladestroms überprüft werden, ob das Relais nach dem Auslösen des Öffnens des Relais geöffnet ist. Weist das Relais einen geöffneten Zustand auf, wird bevorzugt ein Steuersignal zum Öffnen des Schützes generiert.

Das vorgeschlagene Verfahren könnte es ermöglichen, die Schnellabschaltung des Ladevorgangs zu beschleunigen. Dies ist insbesondere darauf zurückzuführen, dass bei dem vorgeschlagenen Verfahren zum Laden des Elektrofahrzeugs das Schütz und das Relais zusammen verwendet werden, wobei das Relais im Vergleich zu dem Schütz die kürzere Nennschaltzeit aufweist. Im Allgemeinen ist das Relais schwächer dimensioniert als das Schütz. Dies bedeutet, dass das das Relais z.B. im Gegensatz zum Schütz über weniger massive Schaltkontakte und auch keine Lichtbogenlöscheinrichtung verfügt, dafür aber schneller schalten kann als das Schütz.

In Fällen von Kurzschlüssen oder Fehlströmen während des Ladevorgangs kann das Steuersignal zur Schnellabschaltung generiert werden und an die Sicherheitsschaltung gesendet werden. Um in derartigen Fällen trotzdem das Relais zur Schnellabschaltung des Ladevorgangs verwenden zu können, wird bei dem vorgeschlagenen Verfahren zum Laden zunächst die aktuelle Schaltzeit des Relais durch Auswertung der ersten Testspannung oder der Stromstärke des ersten Teststroms ermittelt und diese für eine Bestimmung des Schaltauslösezeitpunktes verwendet. Beispielsweise kann der Schaltauslösezeitpunkt derart bestimmt werden, dass zu dem gewünschten Schaltzeitpunkt des Relais die Spannung oder die Stromstärke des Ladestroms, der durch das Relais fließt, annähernd gleich null ist. Durch ein Schalten des Relais zu einem Zeitpunkt, in welchem die Spannung oder die Stromstärke des Ladestroms annähernd gleich null ist, könnte ein Risiko der Lichtbogenbildung an den Lastkontakten des Relais reduziert werden. Wird das Risiko der Lichtbogenbildung an den Lastkontakten reduziert, könnte ein Risiko, dass das Relais durch die Lichtbogenbildung beschädigt wird und/oder ein Risiko, dass aufgrund des Lichtbogens trotz des Abschaltens des Relais weiterhin Strom zwischen den Lastkontakten fließt, minimiert werden.

Das Ermitteln der aktuellen Schaltzeit des Relais ermöglicht es demnach, das Relais und nicht nur das Schütz allein zur Schnellabschaltung des Ladevorgangs zu verwenden. Bei dem vorgeschlagenen Verfahren wird zur Sicherheit, bevorzugt gleichzeitig mit dem Empfang des Steuersignal zur Schnellabschaltung, auch der Schaltkontakt des Schützes geöffnet. Dies könnte eine Sicherheit des Ladevorgangs weiter erhöhen. Ein Steuersignal zum Öffnen des Schaltkontaktes des Schützes kann beispielsweise gleichzeitig mit dem Steuersignal zum Schalten des Relais in Reaktion auf das Steuersignal zur Schnellabschaltung generiert werden. Das Steuersignal zur Schnellabschaltung kann bei einer Detektion eines Fehlstroms oder eines Überstroms ausgelöst werden. Sollte es bei einem Öffnen des Relais zu einem zeitlich länger anhaltenden Abrissfunken kommen, kann das Schütz unterstützend zu dem Relais eine Öffnung eines Stromkreises, in dem das Relais angeordnet ist, bewirken. Dies kann bevorzugt mithilfe einer Hardwarelogik realisiert sein. Eine Öffnung des Schaltkontaktes des Schützes dauert in der Regel um ein Vielfaches länger als das Öffnen des Relais. Ein gleichzeitiges Öffnen des Schaltkontaktes des Schützes könnte ermöglichen, dass in einem garantierten Zeitfenster der Stromkreis, in dem sich das Relais befindet, geöffnet wird, falls das Relais nicht ordnungsgemäß geöffnet werden kann. Das garantierte Zeitfenster entspricht einer Zeit zum Öffnen des Schaltkontaktes des Schützes.

Des Weiteren könnte das Ermitteln der aktuellen Schaltzeit des Relais eine Präzision der Schnellabschaltung des Ladevorgangs erhöhen, bei welcher die Stromstärke des Ladestroms, der durch das Relais fließt, zu dem gewünschten Schaltzeitpunkt null beziehungsweise ungefähr gleich null ist. In einer Variante, bei welcher die aktuelle Schaltzeit des Relais nicht berücksichtigt wird (sondern z.B. nur die vom Hersteller angegebene z.B. maximale Nennschaltzeit), kann durch das Messen des zeitlichen Verlaufs der Spannung oder der Stromstärke des Ladestroms das Relais nur ungefähr zu einem Zeitpunkt geschaltet werden, bei welchem die Stromstärke des Ladestroms etwa gleich null ist. Wird hingegen auch die aktuelle Schaltzeit berücksichtigt, könnte dieser Zeitpunkt präziser angesteuert werden.

Die Erfindung erkennt an dieser Stelle, dass die reale Schaltzeit des Relais in der Praxis von vielen Faktoren abhängen könnte. Z.B. könnte das Schaltverhalten eines mechanischen Relais bei hohen (sommerlichen) Umgebungstemperaturen anders sein als bei tiefen (winterlichen) Umgebungstemperaturen. Auch die Luftfeuchtigkeit könnte einen Einfluss auf die exakte reale Schaltzeit des Relais haben.

Im Laufe der Zeit könnten sich außerdem die Schaltzeiten des Relais nach und nach ändern, denn jeder Schaltvorgang könnte die mechanischen Eigenschaften des mechanischen Relais beeinflussen und verändern. Gründe sind unter anderem eine mögliche Korrosion der Lastkontakte des Relais.

So könnte durch das Bestimmen der aktuellen Schaltzeit eine sich über einer Lebensdauer des Relais verändernde Schaltzeit des Relais erfasst werden, wodurch die Präzision der Schnellabschaltung weiter erhöht werden könnte. Des Weiteren könnten durch Bestimmen der aktuellen Schaltzeit Ablagerungen an den Lastkontakten des Relais berücksichtigt werden.

Gemäß einer Ausgestaltung des Verfahrens stimmt die Dauer des Vorschaltintervalls mit der aktuellen Schaltzeit überein. Diese Ausgestaltung stellt eine einfache Variante dar, bei welcher die aktuelle Schaltzeit in die Bestimmung des Schaltauslösezeitpunktes mit einfließt. Vorteilhafterweise wird der Schaltauslösezeitpunkt derart bestimmt, dass dieser um die aktuelle Schaltzeit verschoben vor einem zukünftigen mithilfe des gemessenen zeitlichen Verlaufes der Stromstärke oder Spannung des Ladestroms errechneten Zeitpunkt des zukünftigen Nulldurchgangs der Stromstärke liegt.

In einer weiteren Ausführungsform weist der Testvorgang zusätzlich durch die Sicherheitsschaltung ein Speichern der ermittelten aktuellen Schaltzeit in einem nichtflüchtigen Speicher auf. Bevorzugt weist der Ladevorgang zusätzlich durch die Sicherheitsschaltung ein Ermitteln des Vorschaltintervalls basierend auf der aktuellen Schaltzeit sowie mindestens einer in dem nichtflüchtigen Speicher gespeicherten weiteren historischen Schaltzeit des Relais auf. Die historische Schaltzeit stellt eine Schaltzeit des Relais dar, die zeitlich vor der aktuellen Schaltzeit erfasst wurde. So kann die historische Schaltzeit analog wie die aktuelle Schaltzeit bei einem vorigen Ladevorgang des Elektrofahrzeugs oder eines weiteren Elektrofahrzeugs bestimmt worden sein und dann in dem Speicher abgespeichert worden sein.

Dieser Ausführungsform liegt die Überlegung zugrunde, dass die Schaltzeit des Relais schwanken kann. Des Weiteren ist es möglich, dass der Testvorgang fehlerhaft ist. Wird das Vorschaltintervall in Abhängigkeit von der aktuellen Schaltzeit und zumindest einer der weiteren historischen Schaltzeiten des Relais bestimmt, so kann ein Einfluss des fehlerhaften Testvorgangs minimiert werden. Beispielsweise können die aktuelle Schaltzeit und zumindest einer der weiteren historischen Schaltzeit in jeweils gewichtetem Maße in eine Berechnung des Vorschaltintervalls einfließen.

Beispielsweise kann das Vorschaltintervall in Abhängigkeit von einem Mittelwert der aktuellen Schaltzeit und zumindest einer der weiteren historischen Schaltzeiten berechnet werden. Die historischen Schaltzeiten resultieren vorteilhaft aus einer vorbestimmten Anzahl jüngster Wiederholungen der Ermittlung der jeweilig aktuellen Schaltzeit.

Gemäß einer weiteren Ausführungsform ist das Relais ein Wechselstromrelais. Bei dieser Ausführungsform ist dem Relais eine vorbestimmte minimale Nenn-Steuerspannung zum Schließen des geöffneten Relais zugeordnet, wobei das Relais zur Durchführung des Ladevorgangs mit einer Lade-Steuerspannung, welche größer als die minimale Nenn-Steuerspannung ist, betrieben wird. Vorteilhafterweise weist der Abschaltvorgang zusätzlich vor dem Schaltauslösezeitpunkt ein Absenken der Steuerspannung des Relais auf die minimale Nenn-Steuerspannung auf. Die minimale Nenn-Steuerspannung kann beispielsweise 4,5 bis 6 Volt betragen. Die Lade-Steuerspannung kann in einem Bereich von 9 bis 12 Volt liegen. Nach dem Absenken der Steuerspannung des Relais auf die minimale Nenn-Steuerspannung ist das Relais noch geschlossen.

Dadurch könnte die aktuelle Schaltzeit reduziert werden und die Schnellabschaltung des Ladevorgangs schneller umgesetzt werden. Zusätzlich könnte durch das Absenken der Steuerspannung des Relais auf die minimale Nenn-Steuerspannung eine Verlustleistung des Relais reduziert werden. Eine vorteilhafte Weiterbildung dieser Ausführungsform kann vorsehen, dass bereits beim Durchführen des Testvorgangs vor dem Auslösen des Öffnens oder Schließens des Relais die Steuerspannung des Relais auf die minimale Nenn-Steuerspannung abgesenkt wird. Dadurch könnte die Präzision der Schnellabschaltung weiter erhöht werden, wenn bei der Schnellabschaltung die Steuerspannung des Relais auf die minimale Nenn-Steuerspannung abgesenkt wird.

In einer alternativen Ausführungsform ist vorgesehen, dass das Relais ein Gleichstromrelais ist, wobei das Öffnen des Relais als Reaktion auf den Empfang des Steuersignals zur Schnellabschaltung ein Umpolen der Steuerspannung aufweist. Durch das Umpolen der Steuerspannung kann das Relais mittels elektromagnetischer Kräfte beschleunigt geöffnet werden. Diese Kräfte können z.B. eine Federkraft zum Öffnen des Relais zusätzlich unterstützen. Wird das Relais mittels elektromagnetischer Kräfte geöffnet, so könnte die aktuelle Schaltzeit reduziert werden, wenn das Relais als Gleichstromrelais ausgebildet ist. Vorzugsweise wird auch während des Testvorgangs die Steuerspannung des Relais beim Auslösen des Öffnens oder Schließens des Relais umgepolt.

In einer Weiterbildung weist das Verfahren zum Laden des Elektrofahrzeugs zusätzlich durch die Sicherheitsschaltung, als Reaktion auf den Empfang eines Steuersignals zum Laden des Elektrofahrzeugs nach Durchführung der Schnellabschaltung, ein Anlegen einer zweiten Testspannung an das Relais und ein Messen einer Spannungsantwort oder einer Stromstärkeantwort in einem Leitungsabschnitt, der zwischen dem Relais und dem Ausgangsanschluss angeordnet ist, in Reaktion auf das Anlegen der zweiten Testspannung auf. Vorzugsweise wird überprüft, ob ein Absolutwert der Spannungsantwort oder der Stromstärkeantwort einen vorbestimmten ersten Schwellenwert beziehungsweise zweiten Schwellwert überschreitet.

Diese Weiterbildung könnte ermöglichen, festzustellen, ob das Relais nach dem Auslösen des Öffnens des Relais bei der Schnellabschaltung hängengeblieben ist, d.h. nicht erfolgreich geöffnet werden konnte. Wäre dies der Fall, so würde die Spannungsantwort oder die Stromstärkeantwort den ersten beziehungsweise zweiten Schwellwert überschreiten, da das Relais die zweite Testspannung an den Ausgangsanschluss leitet, wenn es nicht geöffnet ist. Die zweite Testspannung wird derart an das Relais angelegt, dass sich das Relais in einem Leitungsabschnitt zwischen einem Punkt, an dem die zweite Testspannung angelegt wird, und dem Ausgangsanschluss befindet.

Gemäß einer weiteren Ausgestaltung sind dem Relais eine positive Lichtbogen-Schwellspannung und/oder eine positive Lichtbogen-Schwellstromstärke zugeordnet. Bei dieser Ausgestaltung wird davon ausgegangen, dass beim Öffnen des Relais ein Lichtbogen nur dann entstehen wird, falls der Absolutwert der Stromstärke des Ladestroms größer oder gleich der Lichtbogen-Schwellstromstärke ist und / oder falls der Absolutwert der Spannung des Ladestroms größer oder gleich der Lichtbogen-Schwellspannung ist. Bevorzugt erfolgt die Bestimmung des gewünschten Schaltzeitpunkts nun derart, dass der gewünschte Schaltzeitpunkt innerhalb eines Stromstärke-Zeitfensters liegt, in welchem die Stromstärke des Ladestroms kleiner oder gleich der Lichtbogen-Schwellstromstärke ist, und / oder dass der gewünschte Schaltzeitpunkt innerhalb eines Spannungs-Zeitfensters liegt, in welchem die Spannung des Ladestroms kleiner oder gleich der Lichtbogen-Schwellspannung ist. Diese Ausgestaltung sieht insbesondere vor, den gewünschten Schaltzeitpunkt an den Anfang des Spannungs-Zeitfensters oder des Stromstärke-Zeitfensters zu legen. Damit könnte das Risiko einer Lichtbogenbildung an den Lastkontakten des Relais reduziert werden, auch wenn der tatsächlich stattfindende Schaltzeitpunkt nicht mit dem errechneten Zeitpunkt des zukünftigen Nulldurchgangs der Stromstärke übereinstimmt. In einem Beispiel könnte das Relais langsamer schalten als zuvor bestimmt. Durch das Legen des gewünschten Schaltzeitpunkts an den Anfang des Spannungs-Zeitfensters oder des Stromstärke-Zeitfensters könnte dann aber immer noch ausreichend Zeit zur Verfügung stehen, sodass der tatsächliche Schaltzeitpunkt dann noch innerhalb des entsprechenden Zeitfensters zu liegen kommt.

Diese Ausgestaltung könnte noch einen weiteren Vorteil haben: Wird nicht exakt im Spannungs- oder Stromstärke-Nulldurchgang geschaltet, könnte das hierdurch bewusst in Kauf genommene Entstehen kleiner Schaltfunken dazu führen, dass die Lastkontakte des Relais aufgrund der Funkenbildung selbständig "gereinigt" werden.

Das Stromstärke-Zeitfenster beschreibt bevorzugt ein zukünftiges erstes Zeitintervall, in dem die Stromstärke des Ladestroms kleiner oder gleich der Lichtbogen-Schwellstromstärke ist. Analog beschreibt das Spannungs-Zeitfenster bevorzugt ein zukünftiges zweites Zeitintervall, in dem die Spannung des Ladestroms kleiner oder gleich der Lichtbogen-Schwellspannung ist. Das Stromstärke-Zeitfenster und/oder das Spannungs-Zeitfenster werden bevorzugt in Abhängigkeit des gemessenen zeitlichen Verlaufes der Stromstärke beziehungsweise der Spannung des Ladestromes und der Lichtbogen-Schwellstromstärke beziehungsweise der Lichtbogen-Schwellspannung ermittelt. Ferner kann in die Bestimmung der Zeitfenster berücksichtigen: Ein Kontaktmaterial der Schaltkontakte (die den Ladestrom schalten) des Relais und/oder Umgebungsbedingungen wie Umgebungstemperatur und/oder Umgebungsluftfeuchtigkeit des aktuellen Betriebs des Relais. Diese Faktoren können die Entstehung von Lichtbögen an den Relaiskontakten beeinflussen. Vorzugweise weist die Sicherheitsschaltung einen Speicher (z.B. RAM) auf,

Diese Ausgestaltung des Verfahrens könnte es ermöglichen, ein Risiko einer Entstehung des Lichtbogens beim Öffnen des Relais zu verringern. Dadurch könnte die Lebensdauer des Relais erhöht werden.

Für den Fall, dass das Stromstärke-Zeitfenster mit dem Spannungs-Zeitfenster überlappt, ergibt sich insgesamt ein vergrößertes Zeitfenster, umfassend das Stromstärke-Zeitfenster und das Spannungs-Zeitfenster. In diesem Fall liegt der gewünschte Schaltzeitpunkt bevorzugt am Beginn des durch das Stromstärke-Zeitfenster und das Spannungs-Zeitfenster definierten gemeinsamen Zeitfensters.

Nach einer weiteren Variante erfolgt die Bestimmung des gewünschten Schaltzeitpunkts derart, dass, falls keine Überlappung zwischen dem Stromstärke-Zeitfenster und dem Spannungs-Zeitfenster vorliegt, der gewünschte Schaltzeitpunkt innerhalb des Zeitfensters liegt, welches die größte Dauer hat. In vielen Fällen ist eine Dauer des Spannungszeitfensters länger als eine Dauer des Stromzeitfensters, insbesondere dann, wenn mit hohen Stromstärken geladen wird. Beispielsweise kann die Dauer des Spannungszeitfensters bei einer Stromstärke des Ladestroms von etwa 32 Ampere etwa vier Mal so groß wie die Dauer des Stromzeitfensters sein. Des Weiteren schwankt die Dauer des Spannungszeitfensters in der Regel nicht so stark wie die Dauer des Stromzeitfensters. Aus diesen Gründen kann in einer Variante die Regel sein, den gewünschten Schaltzeitpunkts derart zu bestimmen, dass, falls keine Überlappung zwischen dem Stromstärke-Zeitfenster und dem Spannungs-Zeitfenster gegeben ist, der gewünschte Schaltzeitpunkt innerhalb des Spannungs-Zeitfensters liegt. Dies sollte ausreichend Zeit für einen Schaltvorgang des Relais ohne Lichtbogenbildung gewährleisten, selbst wenn das Relais langsamer schalten sollte als zuvor bestimmt. Allgemein könnte vorgesehen sein, dass bei keiner

Überlappung das größtmögliche der beiden Zeitfenster gewählt wird, in welchem der gewünschte Schaltzeitpunkt zu liegen kommen soll.

In einer weiteren Ausgestaltung weist der Abschaltvorgang zusätzlich durch die Sicherheitsschaltung ein Erhöhen eines Zählwertes um eins auf, wenn die zum gewünschten Schaltzeitpunkt gemessene Spannung oder Stromstärke des Ladestroms um mehr als einen vorbestimmten dritten Schwellwert beziehungsweise vierten Schwellwert von einem bei der Bestimmung des gewünschten Schaltzeitpunkts für den gewünschten Schaltzeitpunkt erwarteten Wert der Spannung beziehungsweise der Stromstärke des Ladestroms abweicht. Gemäß dieser Ausgestaltung weist der Abschaltvorgang ein Ausgeben einer Meldung auf, wenn der Zählwert einen vorbestimmten Zähl-Grenzwert erreicht oder überschreitet. Die Meldung weist bevorzugt eine Empfehlung zum Wechseln des Relais auf. Im Rahmen dieser Ausgestaltung weist das Verfahren zusätzlich durch die Sicherheitsschaltung ein Zurücksetzen des Zählwerts auf null als Reaktion auf einen Wechsel des Relais auf.

Der Vorteil der zuletzt genannten Ausgestaltung könnte sein, dass durch Verwendung des Zählwertes die Meldung rechtzeitig vor einem möglichen Versagen des Relais für Wartungspersonal des Ladepunktes angezeigt wird und dadurch ein störungsfreier Betrieb des Ladepunktes bereitgestellt werden könnte. Des Weiteren könnte von Vorteil sein, dass die aktuelle Schaltzeit und die historischen Schaltzeiten überhaupt für eine Wartung des Ladepunktes verwendet werden können. Das mögliche Versagen könnte daraus resultieren, da das Schalten des Relais zu ungünstigen Schaltzeitpunkten möglicherweise zu einer z.B. mehrfachen lichtbogenbedingten Beschädigung der Schaltkontakte des Relais geführt hat. Das mögliche Versagen kann auch Folge eines so genannten "Kontakt-Bounces" sein, bei dem das Relais schließt und dann darauf unerwünscht wieder öffnet und schließt. Dabei kann auch ein Lichtbogen entstehen, wodurch die Lebensdauer des Relais reduziert werden könnte.

Gemäß einer weiteren Ausführungsform weist der Eingangsanschluss und der Ausgangsanschluss jeweils eine vorbestimmte Anzahl P von Außenleitern auf, wobei das Relais eines von P Relais ist. Jedes der P Relais verbindet jeweils schaltend einen entsprechenden der P Außenleiter des Eingangsanschlusses über einen entsprechenden Schaltkontakt des Schützes mit einem entsprechenden der P Außenleiter des Ausgangsanschlusses. Nach dieser Ausführungsform weist das Verfahren durch die Sicherheitsschaltung ein Durchführen des Testvorgangs und des Abschaltvorgangs für jedes der P Relais unabhängig von allen anderen der P Relais auf. Der jeweilige Testvorgang und Abschaltvorgang der jeweiligen P Relais werden bevorzugt jeweils analog nach einer der oben beschriebenen Varianten des Testvorgangs und des Abschaltvorgangs des Relais durchgeführt. Ein jeweiliges Durchführen des Testvorgangs und Abschaltvorgangs des jeweiligen Relais der P Relais analog zu dem Relais umfasst zum Beispiel eine jeweilige Bestimmung eines gewünschten Schaltzeitpunktes des entsprechenden Relais der P Relais.

Bevorzugt werden die P Relais nacheinander getestet. Wird das Steuersignal zur Schnellabschaltung des Ladevorgangs empfangen, werden die P Relais bevorzugt nacheinander abgeschaltet. In der Regel sind zeitliche Verläufe von Stromstärken oder Spannungen in den P Außenleitern um 120 Grad phasenverschoben. Es könnte die Sicherheit der Sicherheitsschaltung und das Laden weiter erhöhen, wenn alle der P Relais abgeschaltet werden, sobald das Steuersignal zur Schnellabschaltung des Ladevorgangs empfangen wird. Dadurch, dass für jedes der P Relais der Testvorgang durchgeführt wird, können unterschiedliche Verschleißzustände und damit unterschiedliche aktuelle Schaltzeiten der P Relais berücksichtigt werden. Dies könnte es ermöglichen, im Falle der Schnellabschaltung jedes der P Relais in einem jeweiligen Strom- und/oder Spannungszeitfenster zu öffnen. Dadurch könnte ein Risiko eines Ausfalls der Ladestation reduziert werden.

Nach einer Weiterbildung einer der oben genannten Ausgestaltungen weisen der Eingangsanschluss und der Ausgangsanschluss zusätzlich jeweils einen Neutralleiter auf, wobei ein weiteres Relais den Neutralleiter des Eingangsanschlusses über einen entsprechenden Schaltkontakt des Schützes mit dem Neutralleiter des Ausgangsanschlusses schaltend verbindet. Ein gewünschter Schaltzeitpunkt für das weitere Relais wird bevorzugt auf einen spätesten der gewünschten Schaltzeitpunkte der P Relais gesetzt. Diese Weiterbildung könnte sicher stellen, dass der Neutralleiter nicht vor einem der P Außenleiter abgeschaltet wird. Dadurch könnte die Sicherheit der Sicherheitsschaltung und das Laden weiter erhöht werden.

Im Rahmen einer weiteren Ausführungsform wird der gewünschte Schaltzeitpunkt derart bestimmt, dass die verbleibende Zeit bis zum gewünschten Schaltzeitpunkt kürzer als eine Periodendauer des Ladestroms oder der Ladespannung ist. Dadurch könnte vermieden werden, dass der Ladestrom durch das Relais zu einem Zeitpunkt fließt, in welchem die Stromstärke des Ladestroms ihr Maximum erreicht, obwohl bereits das Steuersignal zur Schnellabschaltung des Ladevorgangs empfangen wurde. Dieser Ausführungsform liegt der Gedanke zugrunde, dass der gewünschte Schaltzeitpunkt möglichst auf einen mithilfe der gemessenen Stromstärke oder Spannung des Ladestroms berechneten Zeitpunkt eines nächstmöglichen zukünftigen Nulldurchgang der Stromstärke fällt oder zumindest in der Nähe von dem nächstmöglichen zukünftigen Nulldurchgang liegt. In der Nähe liegen meint, dass das Stromstärke-Zeitfenster den berechneten Zeitpunkt des nächstmöglichen zukünftigen Nulldurchgangs aufweist.

In einer weiteren Ausgestaltung ist vorgesehen, dass die Bestimmung des gewünschten Schaltzeitpunkts derart erfolgt, dass, falls ein Streumaß der aktuellen Schaltzeit und der mindestens einen historischen Schaltzeit einen vorbestimmten Streu-Grenzwert überschreitet, der gewünschte Schaltzeitpunkt innerhalb des Spannungs-Zeitfensters liegt, und andernfalls, dass der gewünschte Schaltzeitpunkt innerhalb des Stromstärke-Zeitfensters liegt. Diese Ausgestaltung des Verfahrens wird bevorzugt angewendet, wenn das Relais eine vergleichsweise hohe Toleranz bezogen auf seine Schaltzeiten aufweist oder, wenn die aktuelle Schaltzeit nur vergleichsweise ungenau ermittelt werden kann. In diesen beiden Fällen hat es sich im Rahmen von praktischen Versuchen als vorteilhaft erwiesen, den gewünschten Schaltzeitunkt innerhalb des Spannungs-Zeitfensters zu legen.

Kann hingegen die aktuelle Schaltzeit vergleichsweise genau, beispielsweise anhand einer Versuchsreihe, bestimmt werden, so hat es sich im Rahmen der praktischen Versuche als vorteilhaft erwiesen, den gewünschten Schaltzeitunkt innerhalb des Strom-Zeitfensters zu legen. Ein Durchführen der Versuchsreihe kann beispielsweise darin bestehen, den Testvorgang mehrere Male hintereinander durchzuführen, bevor der Ladevorgang gestartet wird.

In einem weiteren Aspekt betrifft die Erfindung ein System zum Laden eines Elektrofahrzeugs an einem Ladepunkt. Das System weist eine Sicherheitsschaltung auf. Die Sicherheitsschaltung weist einen versorgungsnetzseitigen Eingangsanschluss, einen elektrofahrzeugseitigen Ausgangsanschluss, ein Schütz und ein Relais auf. Das Relais ist mit dem Ausgangsanschluss verbunden und über einen Schaltkontakt des Schützes mit dem Eingangsanschluss verbunden. Das Relais weist im Vergleich zu dem Schütz eine kürzere Nennschaltzeit auf.

Die Sicherheitsschaltung ist ausgebildet, als Reaktion auf einen Empfang eines Steuersignals zum Laden des Elektrofahrzeugs bei geöffnetem Schaltkontakt des Schützes einen Testvorgang und einen Ladevorgang durchzuführen. Der Testvorgang weist ein Anlegen einer ersten Testspannung an das geöffnete oder geschlossene Relais, ein Auslösen eines Schließens oder Öffnens des Relais bei angelegter erster Testspannung und ein Messen einer durch das Relais geschalteten ersten Testspannung oder einer Stromstärke eines aufgrund der ersten Testspannung durch das Relais fließenden ersten Teststroms während des Schließens oder Öffnens des Relais auf. Weiterhin weist der Testvorgang ein Ermitteln einer aktuellen Schaltzeit des Relais durch Auswertung der ersten Testspannung oder der Stromstärke des ersten Teststroms auf.

Der Ladevorgang weist ein Schließen des Relais auf, falls das Relais bei der Messung der Stromstärke des ersten Teststroms geöffnet wurde. Weiterhin umfasst der Ladevorgang ein Laden des Elektrofahrzeugs mit einem Ladestrom durch Schließen des Schaltkontakts nach dem Schließen des Relais. Weiterhin weist der Ladevorgang ein Messen eines zeitlichen Verlaufs der Spannung und / oder der Stromstärke des Ladestroms während des Ladevorgangs auf.

Weiterhin ist die Sicherheitsschaltung ausgebildet, einen Abschaltvorgang als Reaktion auf einen Empfang eines Steuersignals zur Schnellabschaltung des Ladevorgangs durchzuführen. Der Abschaltvorgangs umfasst ein Bestimmen eines gewünschten Schaltzeitpunkts des Relais basierend auf dem gemessenen zeitlichen Verlauf der Stromstärke und / oder der Spannung des Ladestroms und ein Auslösen eines Öffnens des Relais zu einem Schaltauslösezeitpunkt. Zum Schaltauslösezeitpunkt entspricht die verbleibende Zeit bis zum gewünschten Schaltzeitpunkt einem auf der aktuellen Schaltzeit basierenden Vorschaltintervall. Der Abschaltvorgang umfasst weiterhin ein Öffnen des Schaltkontakts.

In einem weiteren Aspekt betrifft die Erfindung ein Computerprogrammprodukt mit von einem oder mehreren verteilten Prozessoren ausführbaren Instruktionen, wobei die Ausführung der Instruktionen die Prozessoren zur Durchführung des obig beschriebenen Verfahrens veranlasst.

Es sei angemerkt, dass die obig beschriebenen Ausführungsformen der Erfindung in beliebiger Weise miteinander kombiniert werden können, solange sich die kombinierten Ausführungsformen nicht gegenseitig ausschließen.

Im Folgenden werden Ausführungsform der Erfindung andere Zeichnungen näher erläutert. Es zeigen:
Fig. 1 ein System zum Laden eines Elektrofahrzeugs mit einer Sicherheitsschaltung,
Fig. 2 eine schematische Ansicht der Sicherheitsschaltung mit einem Schütz und einem Relais zum Erfassen eines zeitlichen Verlaufes einer Stromstärke oder einer Spannung eines Ladestroms zum Laden des Elektrofahrzeugs,
Fig. 3 den zeitlichen Verlauf der Stromstärke und der Spannung des Ladestroms,
Fig. 4 ein Flussdiagramm eines Verfahrens zum Laden eines Elektrofahrzeugs mit dem System nach Figur 1,
Fig. 5 eine weitere Variante des in Figur 1 gezeigten Systems.

Im Folgenden werden einander ähnliche Elemente mit den gleichen Bezugszeichen gekennzeichnet.

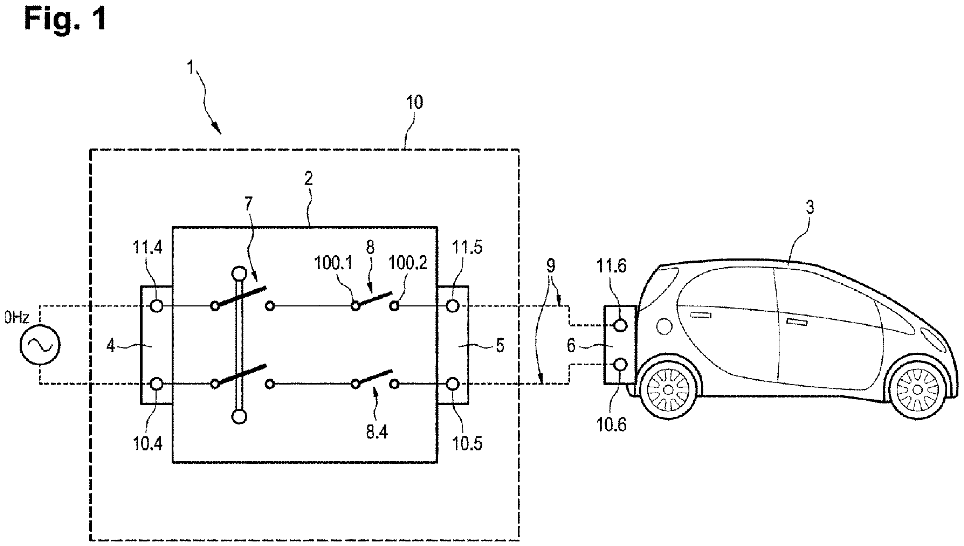

Fig. 1 zeigt ein System 10 zum Laden eines Elektrofahrzeugs 3 an einem Ladepunkt 1. Der Ladepunkt 1 kann beispielsweise in Form einer Ladesäule, die mit einem Gebäude über eine Stromleitung verbunden ist, ausgebildet sein. Der Ladepunkt 1 umfasst zumindest das System 10. Das System 10 weist eine Sicherheitsschaltung 2 mit einem versorgungsnetzseitigen Eingangsanschluss 4 und einem elektrofahrzeugseitigen Ausgangsanschluss 5 auf.

Gemäß der in Fig. 1 gezeigten Variante der Sicherheitsschaltung 2 weist der versorgungsnetzseitige Eingangsanschluss 4 einen ersten Außenleiter 11.4 und einen Neutralleiter 10.4, der Ausgangsanschluss 5 einen ersten Außenleiter 11.5 und einen Neutralleiter 10.5 auf. Weiterhin weist die Sicherheitsschaltung 2 ein Schütz 7 und ein Relais 8 auf, wobei das Relais 8 mit dem Ausgangsanschluss 5 verbunden ist und über einen Schaltkontakt des Schützes 7 mit dem Eingangsanschluss 4 verbunden ist. Der Einfachheit halber ist in Fig. 1 lediglich der Schaltkontakt des Schützes 7 dargestellt. Die Sicherheitsschaltung weist bevorzugt ein weiteres Relais 8.4 auf, das mit dem Ausgangsanschluss 5 verbunden ist und über einen weiteren Schaltkontakt des Schützes 7 mit dem Eingangsanschluss 4 verbunden ist. Das Relais 8 weist im Vergleich zum Schütz 7 eine kürzere Nennschaltzeit auf. Analog weist das weitere Relais 8.4 im Vergleich zum Schütz 7 eine kürzere Nennschaltzeit auf. Das Relais 8 weist einen ersten Lastkontakt 100.1 und einen zweiten Lastkontakt 100.2 auf. Ist das Relais 8 geschlossen, ist der erste Lastkontakt 100.1 mit dem zweiten Lastkontakt 100.2 leitend verbunden. Im geöffneten Zustand des Relais kann kein Strom zwischen dem ersten Lastkontakt 100.1 und dem zweiten Lastkontakt 100.2 fließen. Ein Öffnen und Schließen des Relais kann durch ein Ansteuern zumindest eines Steuerkontaktes 100.3 des Relais bewirkt werden.

Fig. 1 zeigt einen Zustand des Systems 10, bei welchem der Ausgangsanschluss 5 mit einem Eingangsanschluss 6 des Fahrzeugs 3 verbunden ist. In diesem Zustand sind zumindest der Außenleiter 11.5 des Ausgangsanschlusses 5 mit einem Außenleiter 11.6 des Eingangsanschlusses 6 des Fahrzeugs 3 und der Neutralleiter 10.5 des Ausgangsanschlusses 5 mit einem Neutralleiter 10.6 des
Eingangsanschlusses 6 des Fahrzeugs 3 verbunden. Eine Verbindung zwischen dem Ausgangsanschluss 5 und dem Eingangsanschluss 6 des Fahrzeugs 3 wird bevorzugt über ein Ladekabel 9 hergestellt. Das Ladekabel 9 weist ebenfalls zumindest einen Außenleiter und einen Neutralleiter auf.

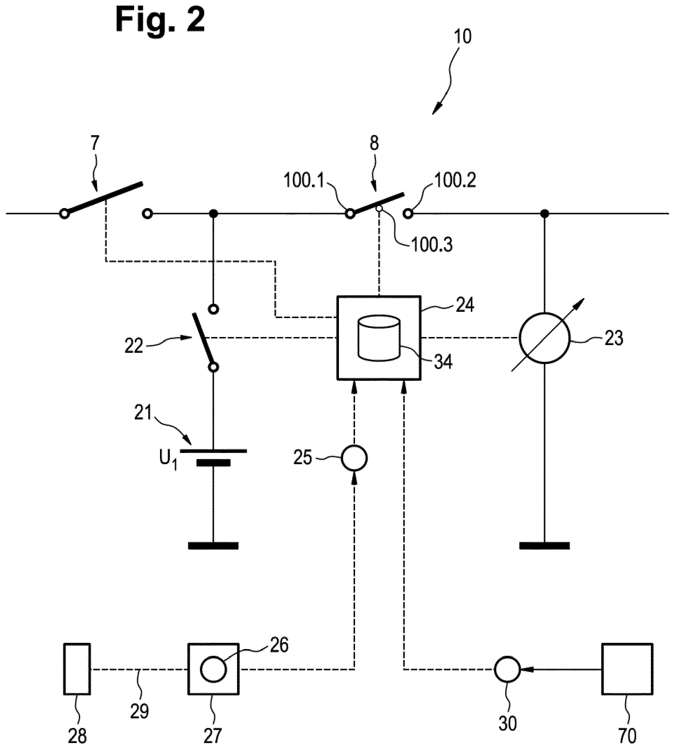

Fig. 2 zeigt eine Variante des Systems 10, bei welcher das System 10 ausgebildet und eingerichtet ist, eine erste Testspannung U₁ an das geöffnete oder geschlossene Relais 8 anzulegen und ein Schließen oder Öffnen des Relais 8 bei angelegter erster Testspannung auszulösen. Weiterhin ist das System 10 nach der in Fig. 2 gezeigten Variante ausgebildet und eingerichtet, während des Schließens oder Öffnens des Relais die durch das Relais 8 geschaltete erste Testspannung U₁ zu messen und eine aktuelle Schaltzeit des Relais 8 durch Auswertung der ersten Testspannung zu ermitteln. Hierzu weist das System 10 bevorzugt eine Spannungsquelle 21, einen Schalter 22, ein z.B. Spannungsmessgerät 23 und ein Steuergerät 24 auf. Das Steuergerät 24 ist bei der in Fig. 2 gezeigten Ausgestaltung ausgebildet und eingerichtet, den Schalter 22 in Abhängigkeit von einem Startsignal 25 zu schalten und die durch das Relais 8 geschaltete erste Testspannung, die mit Hilfe des Spannungsmessgerätes 23 messbar ist, auszuwerten. In einer nicht in Figur 2 gezeigten Variante ist das Steuergerät 24 ausgebildet und eingerichtet, eine Stromstärke eines aufgrund der ersten Testspannung durch das Relais 8 fließenden ersten Teststroms auszuwerten. Alternativ oder zusätzlich kann hierzu ein in Figur 2 nicht dargestelltes Strommessgerät verwendet werden.

Wie mit Hilfe des Systems 10 die aktuelle Schaltzeit des Relais 8 bestimmt werden kann, soll im Folgenden beschrieben werden. Im Folgenden wird angenommen, dass sich das Elektrofahrzeug 3 in der Nähe des Systems 10 zum Laden einer Batterie des Elektrofahrzeugs 3 befindet. Bevorzugt wird vor dem Laden des Fahrzeugs 3 ein Steuersignal 26 zum Laden des Elektrofahrzeugs 3 generiert. Vorteilhafterweise weist das System 10 eine Zentraleinheit 27 zum Generieren des Steuersignals 26 auf. Das Steuersignal 26 kann beispielsweise in Reaktion auf eine Eingabe eines Benutzers, z.B. einer Ladeanforderung, mittels einer Schnittstelle 28 erzeugt werden. Hierzu kann eine Kommunikationsverbindung 29 zwischen der Schnittstelle 28 und der Zentraleinheit 27 verwendet werden. Bei der in Fig. 2 gezeigten Ausgestaltung erzeugt die Zentraleinheit 27 ein Startsignal 25 in Abhängigkeit von dem Steuersignal 26 und sendet das Startsignal 25 an das Steuergerät 24. Für den Fall, dass die Schnittstelle 28 ein Display des Systems 10 ist, kann die Kommunikationsverbindung 29 in Form eines Kabels ausgebildet sein. Für den Fall, dass die Schnittstelle 28 in Form eines Mobilgerätes des Benutzers oder des zu ladenden Fahrzeugs ausgestaltet ist, kann die Kommunikationsverbindung 29 durch ein Aussenden von elektromagnetischer Strahlung mittels der Schnittstelle 28 und ein Empfangen der elektromagnetischen Strahlung mit Hilfe eines nicht dargestellten Empfängers des Systems 10 realisiert sein.

Denkbar ist weiterhin, dass das Steuersignal 26 zum Laden des Elektrofahrzeugs 3 dadurch generiert wird, dass eine Verbindung zwischen dem Ausgangsanschluss 5 und dem Eingangsanschluss 6 des Elektrofahrzeugs 3 mittels des Ladekabels 9 hergestellt ist. Dies hat den Vorteil, dass das Laden des Elektrofahrzeugs 3 beginnen kann, sobald eine elektrische Verbindung zwischen dem Ausgangsanschluss 5 und dem Eingangsanschluss 6 des Elektrofahrzeugs 3 hergestellt ist. Bei dieser Variante können beispielsweise administrative Datenverarbeitungsschritte mit Hilfe der Zentraleinheit 27 bereits während einer Annäherung des Elektrofahrzeugs 3 an das System 10 durchgeführt werden. Die Datenverarbeitungsschritte können beispielsweise ein Freigeben des Systems 10 für einen Ladevorgang für das Elektrofahrzeug 3 umfassen. Das Freigeben kann beispielsweise an eine Verifikation eines Bezahlvorgangs geknüpft sein.

Nach einem Empfangen des Startsignals 25 schließt das Steuergerät 24 den Schalter 22. Dadurch wird die erste Testspannung an das geöffnete oder geschlossene Relais 8 angelegt. In Fig. 2 ist das Relais 8 in einem geöffneten Zustand dargestellt. Möglich ist jedoch auch, dass das Relais 8 bei einem Anlegen der ersten Testspannung geschlossen ist. Ist das Relais 8 bei angelegter erster Testspannung geöffnet, schließt das Steuergerät 24 das Relais 8, nachdem die erste Testspannung an das Relais 8 angelegt wurde. Während des Schließens oder Öffnens des Relais 8 wertet das Steuergerät 24 die durch das Relais 8 geschaltete erste Testspannung oder die Stromstärke des ersten Teststroms aus. Fig. 2 zeigt eine Variante, bei welcher das Steuergerät 24 die durch das Relais 8 geschaltete erste Testspannung auswertet. Zur Auswertung der durch das Relais 8 geschalteten ersten Testspannung empfängt das Steuergerät 24 Messsignale des Spannungsmessgerätes 23. Die Messsignale des Spannungsmessgerätes 23 werden mit Hilfe des Steuergerätes 24 vorzugsweise dadurch empfangen, indem das Steuergerät 24 einen Ausgang des Spannungsmessgerätes 23 abtastet.

Mit Hilfe des Steuergerätes 24 kann die aktuelle Schaltzeit des Relais 8 durch die Auswertung der ersten Testspannung oder der Stromstärke des ersten Teststroms ermittelt werden. Die Auswertung kann beispielsweise ein Messen einer Zeit umfassen, die zwischen dem Schalten des Schalters 22 und einem Empfangen eines Messsignals des Spannungsmessgerätes 23 vergeht, wobei das empfangene Messsignal etwa gleich der ersten Testspannung U₁ ist. Die derartig gemessene Zeitspanne entspricht gemäß diesem Beispiel der aktuellen Schaltzeit des Relais 8.

Das Anlegen der ersten Testspannung, das Auslösen des Schließens oder Öffnens des Relais 8, das Messen der durch das Relais 8 geschalteten ersten Testspannung oder der Stromstärke des ersten Teststroms und das Ermitteln der aktuellen Schaltzeit des Relais 8 können als Schritte eines Testvorgangs aufgefasst werden. Der Testvorgang wird, wie oben beschrieben, durch das Steuersignal 26 zum Laden des Elektrofahrzeugs 3 bei geöffnetem Schaltkontakt des Schützes 7 initiiert.

Das Schütz 7 ist in den Figuren stets größer als das Relais 8 dargestellt, weil das Schütz 7 in der Regel größer als das Relais 8 dimensioniert ist.

Die Sicherheitsschaltung 2 ist ausgebildet, als Reaktion auf den Empfang des Steuersignals 26 zum Laden des Elektrofahrzeugs 3 bei geöffnetem Schaltkontakt des Schützes 7 den Testvorgang und einen Ladevorgang des Elektrofahrzeugs 3 durchzuführen.

Der Ladevorgang weist ein Schließen des Relais 8 auf, falls das Relais 8 bei der Messung der Stromstärke des ersten Teststroms geöffnet wurde. Wie bereits oben erwähnt, ist es möglich, dass bei einem Empfangen des Startsignals 25 das Relais 8 geschlossen ist und somit während des Testvorgangs geöffnet wird. Der Ladevorgang umfasst weiterhin ein Schließen des Schaltkontaktes des Schützes 7 nach dem Schließen des Relais 8. Durch das Schließen des Schaltkontaktes des Schützes 7 wird das Elektrofahrzeug 3 mit einem Ladestrom geladen. Der Ladevorgang umfasst weiterhin ein Messen eines zeitlichen Verlaufs einer Spannung und/oder einer Stromstärke des Ladestroms. Vorteilhafterweise wird der zeitliche Verlauf der Spannung des Ladestroms mit Hilfe des Spannungsmessgerätes 23 gemessen. Da die Spannung beim Laden um ein Vielfaches höher als die erste Testspannung, beispielsweise mindestens doppelt so hoch, vorteilhafterweise bis zu zehnmal so hoch, ist, kann das Steuergerät 24 vorteilhafterweise einen Sensitivitätsbereich des Spannungsmessgerätes 23 umstellen.

Gemäß einer Variante ist das Messgerät 23 eingerichtet, ein am Messgerät 23 anliegendes Spannungssignal zu begrenzen, so dass dieses nicht höher als die erste Testspannung ist. Weiterhin kann das Messgerät 23 ausgebildet sein, eine Spannung nichtlinear zu erfassen. Ein interner Widerstand des Messgerätes 23 kann im Bereich von 1 kOhm bis 100 kOhm liegen.

Daher können mehrere Relais gleichzeitig getestet werden und es kann ein absinken oder ansteigen der ersten Testspannung gemessen werden. Das Messgerät 23 selbst kann bevorzugt einen relativ konstanten Strom ab ca. 3-5V aufwärts messen und begrenzt vorteilhafterweise eine interne Spannung auf 150V, um eine Verlustleistung des Messgerätes 23 zu reduzieren.

Weiterhin ist die Sicherheitsschaltung 2 ausgebildet und eingerichtet, als Reaktion auf einen Empfang eines Steuersignals 30 zur Schnellabschaltung des Ladevorgangs einen Abschaltvorgang durchzuführen. Der Abschaltvorgang umfasst ein Bestimmen eines gewünschten Schaltzeitpunktes des Relais 8, basierend auf dem gemessenen zeitlichen Verlauf der Stromstärke und/oder der Spannung des Ladestroms.

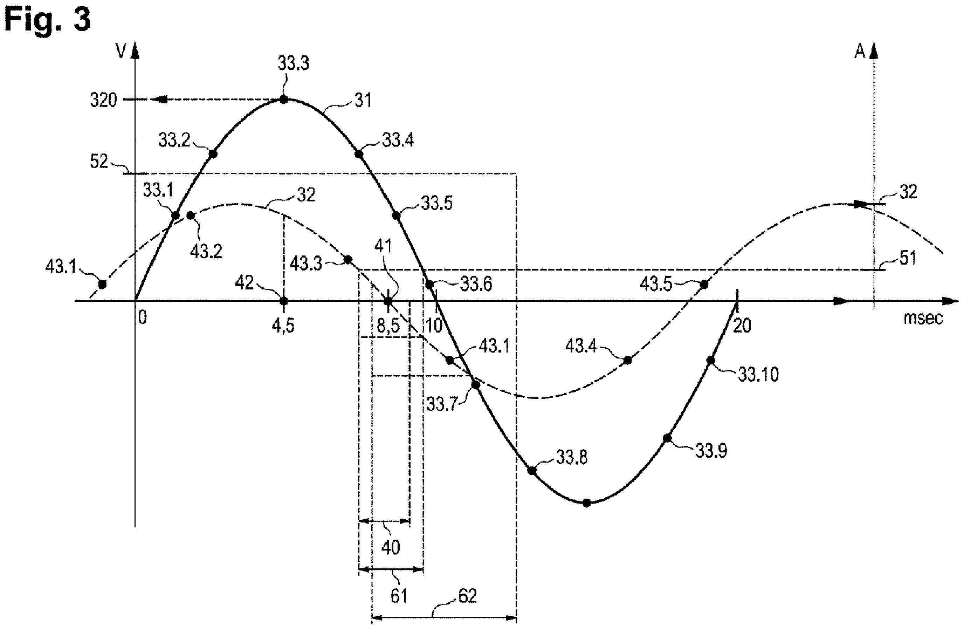

Fig. 3 zeigt den zeitlichen Verlauf der Spannung 31 des Ladestroms und den zeitlichen Verlauf der Stromstärke 32 des Ladestroms. Die in Fig. 3 gezeigten Punkte 33.1, 33.2 bis 33.10 stellen die Messwerte des Spannungsmessgerätes 23 dar, die mit Hilfe des Steuergerätes 24 ausgewertet werden können. Anhand der Messwerte 33.1 bis 33.10 kann das Steuergerät 24 vorteilhafterweise den zeitlichen Verlauf der Spannung 31 des Ladestroms approximieren. Ein derartiges Approximieren kann beispielsweise mit Hilfe eines im Steuergerät 24 implementierten Regressionsverfahrens realisierbar sein. Werte von Parametern zur Beschreibung des zeitlichen Verlaufes der Spannung 31 des Ladestroms sind vorteilhafterweise in einem nichtflüchtigen Speicher 34 des Steuergerätes 24 abgespeichert. Vorteilhafterweise ist das Steuergerät 24 ausgebildet und eingerichtet, den gewünschten Schaltzeitpunkt des Relais 8 mit Hilfe der Werte dieser Parameter zu bestimmen. Bevorzugt ist das Steuergerät 24 ausgebildet, den gewünschten Schaltzeitpunkt des Relais 8 derart zu bestimmen, dass der gewünschte Schaltzeitpunkt innerhalb eines Zeitintervalls 40 liegt, in welchem der zeitliche Verlauf der Stromstärke 32 des Ladestroms einen Nulldurchgang 41 aufweist.

Bevorzugt ist das Steuergerät 24 ausgebildet, den zeitlichen Verlauf der Stromstärke 32 des Ladestroms mit Hilfe des zeitlichen Verlaufes der Spannung 31 des Ladestroms zu bestimmen oder anhand weiterer Messwerte 43.1, 43.2 bis 43.5 zu approximieren. Die weiteren Messwerte 43.1 bis 43.5 können beispielsweise mit Hilfe eines in Fig. 2 nicht dargestellten Strommessgerätes bestimmt werden.

Weiterhin umfasst der Abschaltvorgang ein Auslösen eines Öffnens des Relais 8 zu einem Schaltauslösezeitpunkt. Die zum Schaltauslösezeitpunkt verbleibende Zeit bis zum gewünschten Schaltzeitpunkt entspricht einem auf der aktuellen Schaltzeit basierenden Vorschaltintervall. Vorteilhafterweise ist das Steuergerät 24 eingerichtet, den Schaltauslösezeitpunkt in Abhängigkeit von der aktuellen Schaltzeit und dem gewünschten Schaltzeitpunkt zu berechnen. Eine Berechnung des Schaltauslösezeitpunktes kann beispielsweise zu einem aktuellen Zeitpunkt durchgeführt werden. Der aktuelle Zeitpunkt wird im Folgenden der Einfachheit halber auf einer Zeitachse des in Fig. 3 gezeigten Diagrammes durch den Wert 0 Millisekunden beschrieben. In der praktischen Anwendung liegen die Messwerte des Spannungsmessgerätes 33.1 bis 33.10 natürlich zeitlich vor dem aktuellen Zeitpunkt.

Anhand des zeitlichen Verlaufes der Stromstärke 32 des Ladestroms kann das Steuergerät 24 beispielsweise ermitteln, dass der Nulldurchgang 41 in 8,5 Millisekunden stattfindet. Beträgt die aktuelle Schaltzeit des Relais 8 beispielsweise 4 Millisekunden, so berechnet das Steuergerät 24 den Schaltauslösezeitpunkt bevorzugt derart, dass dieser einen zeitlichen Abstand von 4,5 Millisekunden vom aktuellen Zeitpunkt aufweist. In diesem Fall kann das Steuergerät 24 den Schaltauslösezeitpunkt mit 4,5 Millisekunden angeben und z.B. in einem RAM des Steuergerätes 24 abspeichern.

Das Steuergerät 24 ist weiterhin ausgebildet, ein Öffnen des Relais 8 zu dem Schaltauslösezeitpunkt 42 auszulösen.

Eine mögliche Variante kann vorsehen, dass das Steuergerät 24 eingerichtet ist, das Schütz 7 zu öffnen. Möglich ist, dass das Steuergerät 24 den Schaltkontakt des Schützes 7 mit einer zeitlichen Verzögerung gegenüber dem Auslösen des Öffnens des Relais 8 öffnet. Die zeitliche Verzögerung kann als ein vorbestimmter Wert in dem nichtflüchtigen Speicher 34 abgespeichert sein. Möglich ist weiterhin, dass das Steuergerät 24 den Schaltkontakt des Schützes 7 öffnet, nachdem das Öffnen des Relais 8 erfasst wurde. Das Öffnen des Relais 8 beim Abschaltvorgang kann beispielsweise mit Hilfe des Spannungsmessgerätes 23 und des Steuergerätes 24 detektiert werden.

Bei dem in Fig. 3 gezeigten Ausführungsbeispiel des Systems 10 ist der gewünschte Schaltzeitpunkt derart bestimmt, dass die verbleibende Zeit bis zum gewünschten Schaltzeitpunkt kürzer als eine Periodendauer des Ladestroms ist. Die Periodendauer des Ladestroms beträgt in diesem Fall 20 Millisekunden. Das Relais 8 kann eine positive Lichtbogenschwellstromstärke 51 aufweisen, wobei beim Öffnen des Relais 8 ein Lichtbogen entsteht, falls ein Absolutwert der Stromstärke des Ladestroms größer oder gleich der Lichtbogenschwellstromstärke 51 ist. Ebenfalls kann das Relais 8 eine positive Lichtbogenschwellspannung 52 aufweisen, wobei beim Öffnen des Relais 8 ein Lichtbogen entsteht, falls der Absolutwert der Spannung des Ladestroms größer oder gleich der Lichtbogenschwellspannung 52 ist. Vorteilhafterweise ist die Sicherheitsschaltung 2 eingerichtet, den gewünschten Schaltzeitpunkt derart zu bestimmen, dass der gewünschte Schaltzeitpunkt innerhalb, vorzugsweise zu Beginn eines Stromstärkezeitfensters 61 liegt, in welchem die Stromstärke des Ladestroms kleiner oder gleich der Lichtbogen-schwellstromstärke 51 ist, und/oder dass der gewünschte Schaltzeitpunkt innerhalb, vorzugweise zu Beginn eines Spannungszeitfensters 62 liegt, in welchem die Spannung des Ladestroms kleiner oder gleich der Lichtbogenschwellspannung 52 ist. Allgemein ist es möglich, den gewünschten Schaltzeitpunkt in jenes der Zeitfenster zu legen, welches das Größte der beiden Zeitfenster ist.

Bei dem in Fig. 3 gezeigten Ausführungsbeispiel stellt der Nulldurchgang 41 der Stromstärke des Ladestroms, ausgehend von dem aktuellen Zeitpunkt bei 0 Millisekunden, den nächsten Nulldurchgang der Stromstärke des Ladestroms dar und liegt innerhalb des Spannungszeitfensters 62. Bei dem in Fig. 3 gezeigten Beispiel überlappt das Stromstärkezeitfenster 61 mit dem Spannungszeitfenster 62 zu etwa 80 bis 90 %. In einer Variante erfolgt nun die Bestimmung des gewünschten Schaltzeitpunktes bevorzugt derart, dass der gewünschte Schaltzeitpunkt innerhalb, bevorzugt zu Beginn des durch die beiden Zeitfenster 61 und 62 definierten Zeitraums liegt, also im vorliegenden Beispiel am Beginn des Stromzeitfensters 61 liegt. Das Stromstärkefenster 61, das Spannungszeitfenster 62 und das Zeitintervall 40 sind in der Fig. 3 größer eingezeichnet als dies in den meisten praktischen Anwendungen der Fall ist. Jedoch soll Fig. 3 nur das Prinzip einer möglichen Ausgestaltung der Erfindung veranschaulichen.

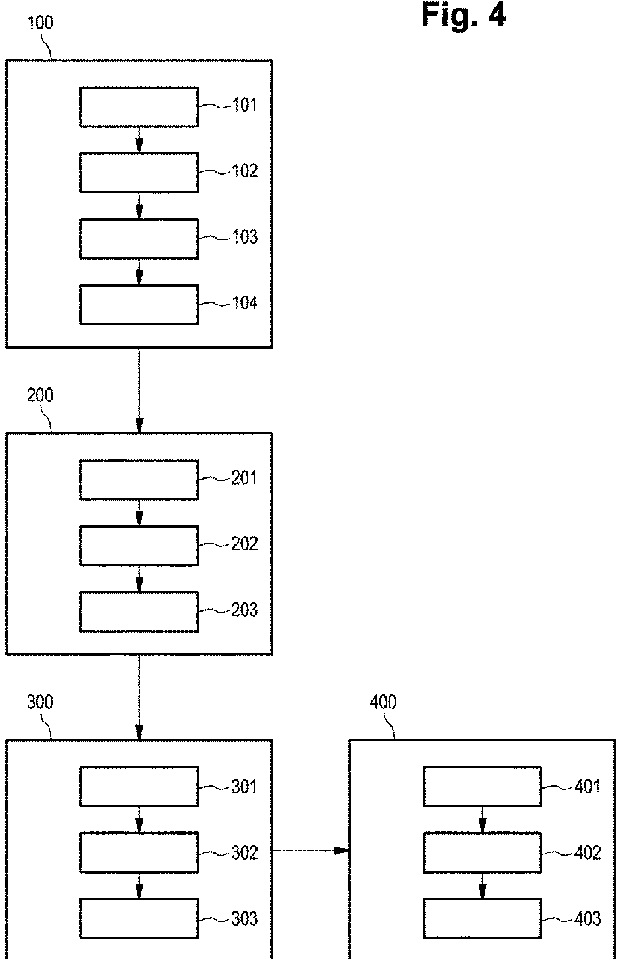

Im Folgenden soll beschrieben werden, wie das System 10, insbesondere die Sicherheitsschaltung 2, zum Laden des Elektrofahrzeugs 3 verwendet werden kann. Fig. 4 zeigt ein Flussdiagramm eines Verfahrens zum Laden des Elektrofahrzeugs 3 an dem Ladepunkt 1. Das Flussdiagramm gibt einen allgemeinen Überblick über einige Möglichkeiten, wie das Elektrofahrzeug 3 mit Hilfe des Systems 10, insbesondere der Sicherheitsschaltung 2, geladen werden kann, wobei nicht alle in Fig. 4 gezeigten Schritte zwingend notwendig sind.

Besonders vorteilhaft wird das im Folgenden beschriebene Verfahren zum Laden des Elektrofahrzeugs 3 mit Hilfe des Steuergerätes 24 durchgeführt. Das in Fig. 2 dargestellte Steuergerät 24 stellt insbesondere ein Beispiel für eine Hardwareeinheit dar, mit welcher das Verfahren ausgeführt werden kann. Genauso gut könnte das Verfahren auch mit Hilfe der Zentraleinheit 27 ausgeführt werden. Denkbar ist zum Beispiel, dass das Steuergerät 24 oder eine weitere Hardwareeinheit mit vergleichbaren Funktionen in der Zentraleinheit 27 integriert ist.

In Reaktion auf den Empfang des Steuersignals 26 zum Laden des Elektrofahrzeugs 3 wird der Testvorgang in Schritt 100 durchgeführt. Das Steuersignal 26 wird bevorzugt bei geöffnetem Schaltkontakt des Schützes 7 empfangen. Der Schritt 100, das heißt der Testvorgang, weist die folgenden Teilschritte 101, 102, 103 auf. In Teilschritt 101 wird die erste Testspannung U₁ an das geöffnete oder geschlossene Relais 8 angelegt. In Teilschritt 102 wird das Schließen oder Öffnen des Relais 8 bei angelegter erster Testspannung ausgelöst. In Teilschritt 103 wird die durch das Relais 8 geschaltete erste Testspannung oder die Stromstärke des aufgrund der ersten Testspannung durch das Relais 8 fließenden ersten Teststroms gemessen. Der Teilschritt 103 erfolgt während des Schließens oder Öffnens des Relais 8. Bevorzugt schließt sich der Teilschritt 103 unmittelbar an den Teilschritt 102 an. In Teilschritt 104 wird durch die Auswertung der ersten Testspannung oder der Stromstärke des ersten Teststroms die aktuelle Schaltzeit des Relais 8 ermittelt. Der Testvorgang in Schritt 100 wird vorteilhafterweise durchgeführt, wenn das Elektrofahrzeug 3 noch nicht an dem Ladepunkt 1 angeschlossen ist. Dadurch könnte der Testvorgang besser kontrolliert werden.

Über die Kommunikationsverbindung 29 wird beispielsweise das Steuersignal 26 zum Laden des Elektrofahrzeugs 3 empfangen. In Abhängigkeit von dem Steuersignal 26 erzeugt die Zentraleinheit 27 bevorzugt das Startsignal 25, welches den Testvorgang, der mit Hilfe des Steuergerätes 24 durchführbar ist, startet. Während des Testvorgangs schaltet das Steuergerät 24 vorteilhafterweise den Schalter 22, das heißt das Steuergerät 24 schließt den Schalter 22, sodass die erste Testspannung an dem geöffneten oder geschlossenen Relais anliegt. Hierbei wird die erste Testspannung vorteilhafterweise an einem Leitungsabschnitt angelegt, der sich zwischen dem Relais 8 und dem Schütz 7 befindet. Nach dem Schließen des Schalters 22 schaltet das Steuergerät 24 das Relais, das heißt das Steuergerät schließt oder öffnet das Relais 8.

Mit Hilfe der Messsignale des Spannungsmessgerätes 23 wertet das Steuergerät 24 vorteilhafterweise die erste Testspannung oder die Stromstärke des ersten Teststroms aus.

Das Verfahren zum Laden weist weiterhin den Ladevorgang in Form des Schrittes 200 auf. Im Sinne der Erfindung wird das Laden des Elektrofahrzeugs 3 demnach in eine erste Phase, in welcher der Testvorgang durchgeführt wird, und in eine zweite Phase, in der der eigentliche Ladevorgang ausgeführt wird, unterteilt. Vorteilhafterweise wird das Verfahren derart durchgeführt, dass sich keine zeitliche Überschneidung zwischen dem Testvorgang und dem Ladevorgang ergibt. Dies erhöht insbesondere die Sicherheit der Sicherheitsschaltung 2 und des Systems 10. Der Schritt 200, das heißt der Ladevorgang, weist die folgenden Teilschritte 201, 202, 203 auf. In Teilschritt 201 wird das Relais 8 geschlossen, falls das Relais 8 bei der Messung der Stromstärke des ersten Teststroms geöffnet wurde. In Teilschritt 202 wird das Elektrofahrzeug 3 mit dem Ladestrom geladen, indem der Schaltkontakt des Schützes 7 geschlossen wird. Der Teilschritt 202 erfolgt nach dem Schließen des Relais 8.

Die Teilschritte 201, 202, 203 können, wie oben beschrieben, mit Hilfe des Spannungsmessgerätes 23 und des Steuergerätes 24 durchgeführt werden.

Das Verfahren zum Laden des Elektrofahrzeugs 3 kann weiterhin als Reaktion auf den Empfang des Steuersignals 30 zur Schnellabschaltung des Ladevorgangs eine Durchführung des Abschaltvorgangs umfassen. Der Abschaltvorgang stellt Schritt 300 des Verfahrens dar. Der Abschaltvorgang umfasst die folgenden Teilschritte 301, 302, 303. In Teilschritt 301 wird der gewünschte Schaltzeitpunkt des Relais 8, basierend auf dem gemessenen zeitlichen Verlauf der Stromstärke und/oder der Spannung des Ladestroms, bestimmt. Dies kann, wie oben beschrieben, mit Hilfe des Steuergerätes 24 oder der Zentraleinheit 27 durch ein Approximieren des zeitlichen Verlaufs der Stromstärke und/oder der Spannung des Ladestroms anhand der Messwerte 33.1 bis 33.10 und/oder der weiteren Messwerte 43.1 bis 43.5 erfolgen. In Teilschritt 302 wird das Öffnen des Relais 8 zu dem Schaltauslösezeitpunkt ausgelöst. Der Schaltauslösezeitpunkt kann, wie oben beschrieben, mit Hilfe des Steuergerätes 24 oder der Zentraleinheit 27 in Abhängigkeit von der aktuellen Schaltzeit und der Auswertung des zeitlichen Verlaufes der Stromstärke und/oder der Spannung des Ladestroms durchgeführt werden. In Teilschritt 303 des Abschaltvorgangs wird der Schaltkontakt des Schützes 7 geöffnet.

Der Einfachheit halber sind sowohl die Teilschritte als auch die Schritte 100, 200, 300 in Fig. 4 so dargestellt, als ob es keine zeitliche Überlappung zwischen den Teilschritten beziehungsweise den Schritten 100, 200, 300 gibt. Dies muss jedoch nicht zwangsläufig der Fall sein. So kann beispielsweise Schritt 300 bereits anfangen, während Schritt 200 noch durchgeführt wird. Es ist beispielsweise denkbar, dass der gewünschte Schaltzeitpunkt des Relais 8 bestimmt wird, während der zeitliche Verlauf der Spannung und/oder der Stromstärke des Ladestroms noch gemessen wird. In diesem Fall könnte der gewünschte Schaltzeitpunkt anhand weiterer aktueller Messwerte korrigiert werden.

Das Steuersignal 30 zur Schnellabschaltung kann beispielsweise mit Hilfe eines Überwachungsmoduls 70 des Systems 10 erzeugt werden. Das Überwachungsmodul 70 ist bevorzugt ausgebildet, eine Fehlfunktion beim Ladevorgang des Fahrzeugs, insbesondere einen Kurzschluss in dem Außenleiter oder dem Neutralleiter des Ladekabels 9 oder innerhalb der Sicherheitsschaltung 2 oder des Fahrzeugs 3 und/oder einen Fehlstrom in dem Außenleiter oder dem Neutralleiter des Ladekabels 9, der Sicherheitsschaltung 2 und/oder dem Elektrofahrzeug 3 zu detektieren. Detektiert das Überwachungsmodul 70 den Kurzschluss oder den Fehlstrom, sendet das Überwachungsmodul 70 bevorzugt das Steuersignal 30 zur Schnellabschaltung an das Steuergerät 24 und/oder die Zentraleinheit 27.

Vorteilhafterweise speichert das Steuergerät 24 die aktuelle Schaltzeit in dem Speicher 34. Insbesondere speichert das Steuergerät 24 bei jeder Wiederholung des Testvorgangs eine dabei wiederholt ermittelte aktuelle Schaltzeit des Relais 8 in dem Speicher 34. Zu dem aktuellen Zeitpunkt können dann beispielsweise mehrere historische Schaltzeiten in dem Speicher 34 vorliegen. Die historischen Schaltzeiten entsprechen den jeweiligen aktuellen Schaltzeiten, die in einer Vergangenheit bei den jeweiligen Wiederholungen des Testvorgangs ermittelt wurden. Die Dauer des Vorschaltintervalls kann vorteilhafterweise auf einem Mittelwert der aktuellen Schaltzeit und einer oder mehrerer der historischen Schaltzeiten basieren.

Gemäß einer Ausgestaltung kann das Relais 8 ein Wechselstromrelais sein, wobei dem Relais 8 eine vorbestimmte minimale Nennsteuerspannung, beispielsweise 10 Volt, zum Schließen des geöffneten Relais zugeordnet ist. Beim Durchführung des Ladevorgangs 200 wird das Relais 8 vorteilhafterweise zum Schließen des Relais 8 mit einer Ladesteuerspannung betrieben, welche größer als die minimale Nennsteuerspannung ist. Beispielsweise kann die Ladesteuerspannung 12 Volt betragen. Es hat sich als besonders vorteilhaft erwiesen, dass während des Abschaltvorgangs 300 die Steuerspannung des Relais 8 von der Ladesteuerspannung auf die minimale Nennsteuerspannung abgesenkt wird. Dies kann beispielsweise während einer Ausführung des Teilschrittes 301 erfolgen. Wird die Steuerspannung vor dem Auslösen des Öffnens des Relais 8 abgesenkt, kann das Öffnen des Relais 8 beschleunigt werden. Das Öffnen des Relais 8 beginnt mit dem Auslösen des Öffnens und endet dann, wenn der Ladestrom nicht mehr durch das Relais 8 fließen kann. In diesem Fall kann das Spannungsmessgerät 23 einen Spannungsabfall detektieren oder einen Messwert erzeugen, der etwa 0 Volt beträgt.

In einem weiteren Ausführungsbeispiel ist das Relais 8 ein Gleichstromrelais. Vorteilhafterweise umfasst das Öffnen des Relais 8 ein Umpolen der Steuerspannung des Relais 8. Das Umpolen kann beispielsweise als Reaktion auf den Empfang des Steuersignals 30 zur Schnellabschaltung, beispielsweise mit Hilfe des Steuergerätes 24, ausgeführt werden.

Nach dem Durchführen der Schnellabschaltung kann das Verfahren zum Laden des Elektrofahrzeugs 3 einen weiteren Schritt 400 umfassen. Der weitere Schritt 400 kann als eine Art "Relais-Stuck-Test" betrachtet werden. Hierbei wird überprüft, ob das Relais 8 korrekt geöffnet wurde. Der Schritt 400 weist die folgenden Teilschritte auf. In Teilschritt 401 wird eine zweite Testspannung an das Relais 8 angelegt. In Teilschritt 402 wird eine Spannungsantwort oder eine Stromstärkeantwort in einem Leitungsabschnitt zwischen dem Relais und dem Ausgangsanschluss in Reaktion auf das Anlegen der zweiten Testspannung gemessen. Dies kann beispielsweise mit Hilfe des Spannungsmessgerätes 23 erfolgen. In diesem Fall erzeugt das Spannungsmessgerät 23 zweite weitere Messwerte, die an das Steuergerät 24 übertragen werden können.

In Schritt 403 des Relais-Stuck-Tests wird überprüft, ob der Absolutwert der Spannungsantwort oder der Stromstärkeantwort einen vorbestimmten ersten Schwellwert beziehungsweise vorbestimmten zweiten Schwellwert überschreitet. Ist dies der Fall, kann davon ausgegangen werden, dass das Relais 8 nicht ordnungsgemäß bei der Schnellabschaltung geöffnet wurde. Funktioniert das Relais 8 korrekt, so sollte der Absolutwert der Spannungsantwort oder der Stromstärkeantwort bei Durchführung des Relais-Stuck-Tests gleich Null sein. Unterschreitet der Absolutwert der Spannungsantwort oder der Stromstärkeantwort den vorbestimmten ersten Schwellwert beziehungsweise vorbestimmten zweiten Schwellwert, wird das Relais 8 in dem Teilschritt 403 geschlossen.

Wird zum tatsächlichen Schaltzeitpunkt eine Spannung oder Stromstärke des Ladestroms gemessen, die mehr als einen vorbestimmten dritten beziehungsweise vierten Schwellwert von einem bei der Bestimmung des gewünschten Schaltzeitpunkts für den gewünschten Schaltzeitpunkt erwarteten Wert der Spannung beziehungsweise der Stromstärke des Ladestroms abweicht, erhöht die Sicherheitsschaltung 2, insbesondere das Steuergerät 24, einen Zählwert um 1. Erreicht der Zählwert einen vorbestimmten Zählgrenzwert oder überschreitet er diesen, wird eine Meldung ausgegeben. Die Meldung kann beispielsweise an die Zentraleinheit 27 gesendet werden. Die Meldung weist vorteilhaft darauf hin, dass das Relais 8 gewechselt werden muss. Vorteilhafterweise ist das Steuergerät 24 eingerichtet, einen Wechsel des Relais 8 zu detektieren. Dies kann beispielsweise mittels Kontaktsensoren umgesetzt werden. Detektiert das Steuergerät 24 den Wechsel des Relais, setzt das Steuergerät 24 den Zählwert auf 0 zurück. Alternativ ist eine manuelle Rücksetzung möglich. Das Relais 8 kann zusammen mit einem digitalen Temperatursensor auf einer austauschbaren Platine angeordnet sein. Der Temperatursensor kann eine eindeutige Identifikationsnummer aufweisen, welche für eine Inventarkontrolle verwendet werden kann.

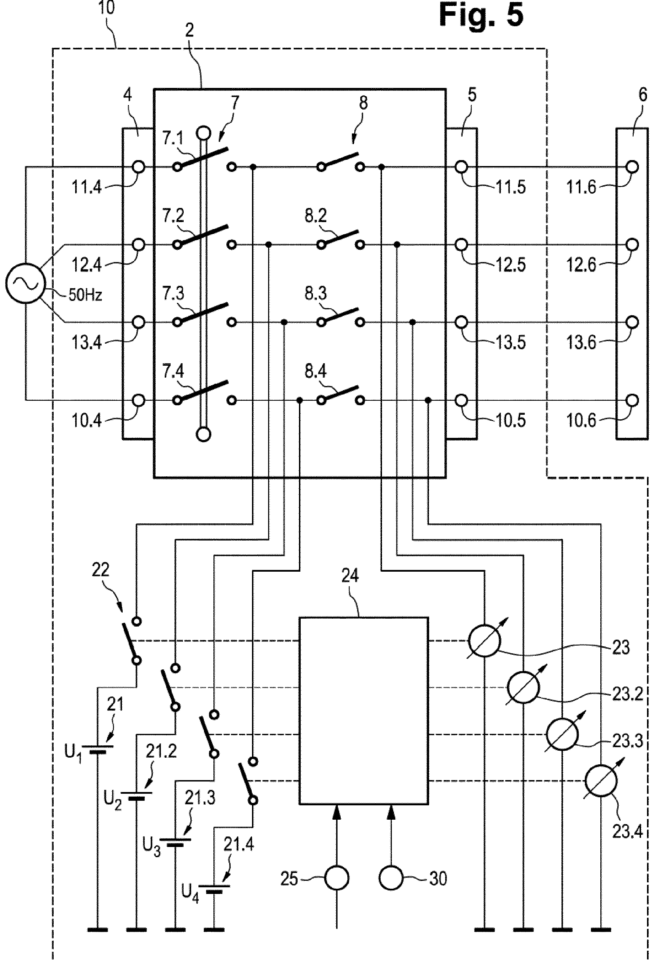

Fig. 5 zeigt eine Ausgestaltung des Systems 10 für einen insbesondere dreiphasigen Ladevorgang, bei welcher der Eingangsanschluss zusätzlich zu dem ersten Außenleiter 11.4 einen zweiten Außenleiter 12.4 und einen dritten Außenleiter 13.4 aufweist. Analog weist der Ausgangsanschluss neben dem ersten Außenleiter 11.5 einen zweiten Außenleiter 12.5 und einen dritten Außenleiter 13.5 auf. Analog weist der Eingangsabschluss 6 des Elektrofahrzeugs 3 neben dem ersten Außenleiter 11.6 einen zweiten Außenleiter 12.6 und einen dritten Außenleiter 13.3 auf. Der zweite Außenleiter 12.4 des Eingangsanschlusses 4 ist über einen zweiten Schaltkontakt 7.2 des Schützes 7 und ein zweites Relais 8.2 der Sicherheitsschaltung 2 mit dem zweiten Außenleiter 12.5 des Ausgangsanschlusses 5 schaltbar verbunden. Sind der zweite Schaltkontakt 7.2 des Schützes 7 und das zweite Relais 8.2 geschlossen, kann ein zweiter Ladestrom über den zweiten Außenleiter 12.4 des Eingangsanschlusses 4 und den zweiten Außenleiter 12.5 des Ausgangsanschlusses 5 zu dem zweiten Außenleiter 12.6 des Eingangsanschlusses 6 des Elektrofahrzeugs 3 fließen.

Analog ist der dritte Außenleiter 13.4 des Eingangsanschlusses 4 über einen dritten Schaltkontakt 7.3 des Schützes 7 und ein drittes Relais 8.3 mit dem dritten Außenleiter 13.5 des Ausgangsanschlusses 5 schaltbar verbunden. Sind der dritte Schaltkontakt 7.3 des Schützes 7 und das dritte Relais 8.3 geschlossen, kann ein dritter Ladestrom von dem dritten Außenleiter 13.4 des Eingangsanschlusses 4 über den dritten Schaltkontakt 7.3 des Schützes 7 und das dritte Relais 8.3 über den dritten Außenleiter 13.5 des Ausgangsanschlusses 5 hin zu dem dritten Außenleiter 13.6 des Eingangsanschlusses 6 fließen.

Der Vollständigkeit halber sind in Fig. 5 ein erster Schaltkontakt 7.1 des Schützes 7 und ein vierter Schaltkontakt 7.4 des Schützes 7 eingezeichnet. Vorteilhafterweise sind die Schaltkontakte 7.1, 7.2, 7.3 und 7.4 gleichzeitig schaltbar, wie es in Fig. 5 eingezeichnet ist.

Das Relais 8, das zweite Relais 8.2, das dritte Relais 8.3 und das weitere Relais 8.4 sind vorteilhafterweise mit Hilfe des Steuergerätes 24 unabhängig voneinander schaltbar. Des Weiteren weist die Sicherheitsschaltung 2 vorteilhafterweise neben der oben beschriebenen Spannungsquelle 21 eine zweite Spannungsquelle 21.2, eine dritte Spannungsquelle 21.3 und eine vierte Spannungsquelle 21.4 auf. Des Weiteren umfasst die Sicherheitsschaltung 2 bevorzugt neben dem Spannungsmessgerät 23 ein zweites Spannungsmessgerät 23.2, ein drittes Spannungsmessgerät 23.3 und ein viertes Spannungsmessgerät 23.4, deren erfasste Messwerte jeweils mit Hilfe des Steuergerätes 24 getrennt voneinander einlesbar und auswertbar sind. Dadurch kann für jedes der Relais 8, 8.2, 8.3, 8.4 ein jeweiliger Testvorgang analog zu dem oben beschriebenen Testvorgang durchgeführt werden.

Des Weiteren ist vorteilhafterweise vorgesehen, dass für jedes der Relais 8, 8.2, 8.3, 8.4 ein jeweiliger Abschaltvorgang analog zu dem oben beschriebenen Abschaltvorgang 300 mit Hilfe des Steuergerätes 24 unabhängig voneinander durchführbar ist. Dies hat den Vorteil, dass die Relais 8, 8.2, 8.3, 8.4 nacheinander abgeschaltet werden können, wenn die Sicherheitsschaltung 2 das Steuersignal 30 zur Schnellabschaltung des Ladevorgangs empfängt.

In einer besonderen Ausgestaltung wird das dritte Relais 8.3 gleichzeitig mit dem weiteren Relais 8.4 im Rahmen einer Durchführung der jeweiligen Abschaltvorgänge geöffnet.

Der Fachmann wird verstehen, dass Aspekte der vorliegenden Erfindung als Gerät, Verfahren oder Computerprogramm oder Computerprogrammprodukt ausgeführt sein können. Entsprechend können Aspekte der vorliegenden Erfindung die Form einer reinen Hardware-Ausführungsform, einer reinen Software-Ausführungsform (darunter Firmware, im Speicher befindliche Software, Mikro-Code, usw.) oder einer Software- und Hardware-Aspekte kombinierenden Ausführungsform annehmen, die hierin alle allgemein als "Schaltkreis", "Modul" oder "System" bezeichnet sein können. Des Weiteren können Aspekte der vorliegenden Erfindung die Form eines Computerprogrammprodukts annehmen, welches durch ein computerlesbares Medium oder durch mehrere computerlesbare Medien in Form von computerausführbarem Code getragen wird. Ein Computerprogramm umfasst ebenfalls den computerausführbarem Code. "Computerausführbarem Code" kann auch als "Computerprogrammanweisungen" bezeichnet werden.

Eine beliebige Kombination von einem oder mehreren computerlesbaren Medium (en) kann verwendet werden. Das computerlesbare Medium kann ein computerlesbares Signalmedium oder ein computerlesbares Speichermedium sein. Ein "computerlesbares Speichermedium", wie hierin verwendet, umfasst ein materielles Speichermedium, das Anweisungen speichern kann, die durch einen Prozessor einer Computervorrichtung ausführbar sind. Das computerlesbare Speichermedium kann als computerlesbares nicht-flüchtiges Speichermedium bezeichnet werden. Das computerlesbare Speichermedium kann auch als ein greifbares computerlesbares Medium bezeichnet werden. In einigen Ausführungsformen kann ein computerlesbares Speichermedium auch in der Lage sein Daten zu speichern, die es ermöglichen, dass durch den Prozessor der Rechnervorrichtung auf sie zugegriffen wird. Beispiele von computerlesbaren Speichermedien umfassen, sind aber nicht beschränkt auf: eine Diskette, eine magnetische Festplatte, eine Festkörper-Festplatte, Flash-Speicher, einen USB-Stick, Random Access Memory (RAM), Festwertspeicher (ROM), eine optische Platte, eine magneto-optische Platte, und die Registerdatei des Prozessors. Beispiele für optische Platten umfassen Compact Disks (CD) und Digital Versatile Disks (DVD), zum Beispiel CD-ROM, CD-RW, CD-R, DVD-ROM, DVD-RW oder DVD-R-Disks. Der Begriff computerlesbares Speichermedium bezieht sich auch auf verschiedene Arten von Aufzeichnungsmedien, die dafür geeignet sind von der Rechnervorrichtung über ein Netzwerk oder eine Kommunikationsverbindung abgerufen zu werden. Zum Beispiel können Daten über ein Modem, über das Internet oder über ein lokales Netzwerk abgerufen werden. Computerausführbarer Code, der auf einem computerlesbaren Medium ausgeführt wird, kann über jedes geeignete Medium übermittelt werden, einschließlich, aber nicht darauf beschränkt, drahtlose, drahtgebundene, Lichtwellenleiter, RF, etc., oder jede geeignete Kombination der vorstehenden Medien.

Ein computerlesbares Signalmedium kann ein ausgebreitetes Datensignal beinhalten, das den computerlesbaren Programmcode zum Beispiel in einem Basissignal (baseband) oder als Teil eines Trägersignals (Trägerwelle) enthält. Solch ein Ausbreitungssignal kann in einer beliebigen Form ausgebildet sein, darunter, jedoch nicht beschränkt auf, eine elektromagnetische Form, eine optische Form oder jede geeignete Kombination davon. Bei einem computerlesbaren Signalmedium kann es sich um ein beliebiges computerlesbares Medium handeln, das kein computerlesbares Speichermedium ist und das ein Programm zur Verwendung durch oder in Verbindung mit einem System, Gerät oder Vorrichtung zur Ausführung von Anweisungen übertragen, verbreiten oder transportieren kann.

"Computer-Speicher" oder "Speicher" ist ein Beispiel für ein computerlesbares Speichermedium. Ein Computer-Speicher ist jeder Speicher, der einem Prozessor direkt zugänglich ist.

"Computer-Datenspeicher" oder "Datenspeicher" ist ein weiteres Beispiel eines computerlesbaren Speichermediums. Computer-Datenspeicher ist jedes nichtflüchtige computerlesbare Speichermedium. In einigen Ausführungsformen kann ein Computerspeicher auch ein Computer-Datenspeicher sein oder umgekehrt.

Ein "Prozessor", wie er hierin verwendet wird, umfasst eine elektronische Komponente, die in der Lage ist, eine programm- oder maschinenausführbare Anweisung oder computerausführbaren Code auszuführen. Eine Bezugnahme auf die Rechnervorrichtung, die einen "Prozessor" umfasst, sollte so interpretiert werden, dass sie möglicherweise mehr als einen Prozessor oder Verarbeitungskerne umfasst. Der Prozessor kann zum Beispiel ein Multi-Core-Prozessor sein. Ein Prozessor kann sich auch auf eine Sammlung von Prozessoren innerhalb eines einzigen Computersystems oder verteilt auf mehrere Computersysteme beziehen. Der Begriff Rechnervorrichtung oder des Computers soll auch so interpretiert werden, um möglicherweise auf eine Sammlung oder ein Netzwerk von Rechnervorrichtungen oder Computern, die jeweils einen Prozessor oder Prozessoren umfassen, hinzuweisen. Der computerausführbare Code kann durch mehrere Prozessoren ausgeführt werden, die innerhalb derselben Rechnervorrichtung oder sogar über mehrere Computer verteilt sein können.

Computerausführbarer Code kann maschinenausführbare Anweisungen oder ein Programm umfassen, das einen Prozessor veranlasst, einen Aspekt der vorliegenden Erfindung durchzuführen. Computerausführbarer Code zum Ausführen von Operationen für Aspekte der vorliegenden Erfindung kann in jeder beliebigen Kombination einer oder mehrerer Programmiersprachen geschrieben sein, darunter eine objektorientierte Programmiersprache wie Java, Smalltalk, C++ oder Ähnliche und herkömmliche verfahrensorientierte Programmiersprachen wie die Programmiersprache "C" oder ähnliche Programmiersprachen, und in maschinenausführbare Anweisungen übersetzt werden. In einigen Fällen kann der computerausführbare Code in der Form einer höheren Programmiersprache oder in einer vor-übersetzten Form vorliegen, und in Verbindung mit einem Interpreter verwendet werden, der die maschinenausführbaren Anweisungen generiert.

Der computerausführbare Code kann vollständig auf dem Rechner eines Benutzers, teilweise auf dem Rechner des Benutzers, als eigenständiges Software-Paket, teilweise auf dem Rechner des Benutzers und teilweise auf einem entfernt angeordneten Rechner oder vollständig auf dem entfernt angeordneten Rechner oder Server ausgeführt werden. In letzterem Fall kann der entfernt angeordnete Rechner mit dem Rechner des Benutzers durch eine beliebige Art von Netzwerk verbunden sein, einschließlich einem lokalen Netzwerk (LAN) oder einem Weitverkehrsnetz (WAN), oder die Verbindung kann mit einem externen Rechner hergestellt werden (zum Beispiel über das Internet unter Verwendung eines Internet-Dienstanbieters).

Die Computerprogrammanweisungen können auf einem Prozessor oder auf mehreren Prozessoren ausgeführt werden. Im Falle mehrerer Prozessoren können diese auf mehre unterschiedliche Entitäten (z.B. Clients, Servern) verteilt sein. Jeder Prozessor könnte einen für die jeweilige Entität vorgesehenen Teil der Instruktionen ausführen. Wenn also von einem System oder Verfahren die Rede ist, das mehrere Entitäten umfasst, so verstehen sich die Computerprogrammanweisungen so, dass diese so angepasst sind, um durch einen der jeweiligen Entität zugeordneten oder zugehörigen Prozessor ausgeführt zu werden.

Aspekte der vorliegenden Erfindung werden unter Bezugnahme auf Flussdiagramm-Darstellungen und/oder Blockschaltbilder von Verfahren, Vorrichtungen (Systemen) und Computerprogramm-produkten gemäß Ausführungsformen der Erfindung beschrieben. Es wird darauf hingewiesen, dass jeder Block oder Teile der Blöcke der Flussdiagramme, Darstellungen und/oder der Blockschaltbilder durch Computerprogrammanweisungen, gegebenenfalls in Form eines computerausführbaren Codes, ausgeführt werden können. Es wird weiter darauf hingewiesen, dass Kombinationen von Blöcken in verschiedenen Flussdiagrammen, Darstellungen und/oder Blockschaltbildern kombiniert werden können, wenn sie sich nicht gegenseitig ausschließen. Diese Computerprogrammanweisungen können einem Prozessor eines Universalrechners, Spezialrechners oder einer anderen programmierbaren Datenverarbeitungsvorrichtung bereitgestellt werden, um eine Vorrichtung zu erzeugen, so dass die über den Prozessor des Computers oder der anderen programmierbaren Datenverarbeitungsvorrichtung ausgeführten Anweisungen Mittel zur Ausführung der in dem Block oder den Blöcken der Flussdiagramme und/oder der Blockschaltbilder festgelegten Funktionen/Schritte erzeugen.

Diese Computerprogrammanweisungen können auch auf einem computerlesbaren Medium gespeichert sein, die einen Computer oder andere programmierbare Datenverarbeitungsvorrichtungen oder andere Vorrichtungen steuern können, dass sie auf eine bestimmte Art funktionieren, so dass die auf dem computerlesbaren Medium gespeicherten Anweisungen ein Herstellungserzeugnis hervorrufen, einschließlich Anweisungen, welche die/den in dem Block oder den Blöcken der Flussdiagramme und/oder der Blockschaltbilder festgelegte/n Funktion/Schritt umsetzen.

Die Computerprogrammanweisungen können auch auf einen Computer, anderen programmierbaren Datenverarbeitungs-vorrichtungen oder anderen Vorrichtungen gespeichert werden, um die Ausführung einer Reihe von Prozessschritten auf dem Computer, anderen programmierbaren Datenverarbeitungsvorrichtungen oder anderen Vorrichtungen zu verursachen, um einen auf einem Computer ausgeführten Prozess zu erzeugen, so dass die auf dem Computer oder den anderen programmierbaren Vorrichtungen ausgeführten Anweisungen Verfahren zur Umsetzung der in dem Block oder den Blöcken der Flussdiagramme und/oder der Blockschaltbilder festgelegten Funktionen/Schritte erzeugen.

## Patentansprüche

1. Verfahren zum Laden eines Elektrofahrzeugs (3) an einem Ladepunkt (1) unter Verwendung einer Sicherheitsschaltung (2), wobei die Sicherheitsschaltung (2) aufweist:
- einen versorgungsnetzseitigen Eingangsanschluss (4) und einen elektrofahrzeugseitigen Ausgangsanschluss (5),
- ein Schütz (7) und ein Relais (8), wobei das Relais (8) mit dem Ausgangsanschluss (5) verbunden ist und über einen Schaltkontakt des Schützes (7) mit dem Eingangsanschluss (4) verbunden ist, wobei das Relais (8) im Vergleich zum Schütz (7) eine kürzere Nennschaltzeit aufweist,
- eine Spannungsquelle (21), ein Messgerät (23) und ein Steuergerät (24),
wobei das Verfahren durch die Sicherheitsschaltung (2) aufweist:
- als Reaktion auf einen Empfang eines Steuersignals (26) zum Laden des Elektrofahrzeugs (3) bei geöffnetem Schaltkontakt des Schützes (7), Durchführen eines Testvorgangs und eines Ladevorgangs, wobei der Testvorgang aufweist:
- Anlegen einer ersten Testspannung an das geöffnete oder geschlossene Relais (8),
- Auslösen eines Schließens oder Öffnens des Relais (8) bei angelegter erster Testspannung,
- während des Schließens oder Öffnens des Relais (8), Messen einer durch das Relais (8) geschalteten ersten Testspannung oder einer Stromstärke eines aufgrund der ersten Testspannung durch das Relais (8) fließenden ersten Teststroms,
- Ermitteln einer aktuellen Schaltzeit des Relais (8) durch Auswertung der ersten Testspannung oder der Stromstärke des ersten Teststroms,
wobei der Ladevorgang aufweist:
- falls das Relais (8) bei der Messung der Stromstärke des ersten Teststroms geöffnet wurde, Auslösen eines Schließens des Relais (8),
- nach dem Schließen des Relais (8), Laden des Elektrofahrzeugs (3) mit einem Ladestrom durch Auslösen eines Schließens des Schaltkontaktes des Schützes (7),
- während des Ladevorgangs, Messen eines zeitlichen Verlaufs der Spannung und / oder der Stromstärke des Ladestroms;
- als Reaktion auf einen Empfang eines Steuersignals (30) zur Schnellabschaltung des Ladevorgangs, Durchführen eines Abschaltvorgangs umfassend:
- basierend auf dem gemessenen zeitlichen Verlauf der Stromstärke und / oder der Spannung des Ladestroms, Bestimmen eines gewünschten Schaltzeitpunkts des Relais (8),
- Auslösen eines Öffnens des Relais (8) zu einem Schaltauslösezeitpunkt, wobei zum Schaltauslösezeitpunkt die verbleibende Zeit bis zum gewünschten Schaltzeitpunkt einem auf der aktuellen Schaltzeit basierenden Vorschaltintervall entspricht,
- Auslösen eines Öffnens des Schaltkontakts.

2. Verfahren nach Anspruch 1, wobei die Dauer des Vorschaltintervalls mit der aktuellen Schaltzeit übereinstimmt.

3. Verfahren nach einem der vorigen Ansprüche, wobei der Testvorgang zusätzlich durch die Sicherheitsschaltung (2) ein Speichern der ermittelten aktuellen Schaltzeit in einem nichtflüchtigen Speicher (34) aufweist, wobei der Ladevorgang zusätzlich durch die Sicherheitsschaltung (2) ein Ermitteln des Vorschaltintervalls basierend auf der aktuellen Schaltzeit sowie mindestens einer in dem nichtflüchtigen Speicher (34) gespeicherten weiteren historischen Schaltzeit des Relais (8) aufweist.

4. Verfahren nach Anspruch 3, wobei die Dauer des Vorschaltintervalls auf einem Mittelwert der aktuellen Schaltzeit und einer oder mehreren der historischen Schaltzeiten, welche aus einer vorbestimmten Anzahl jüngster Wiederholungen der Ermittlung der aktuellen Schaltzeit resultieren, basiert.

5. Verfahren nach einem der vorigen Ansprüche, wobei das Relais (8) ein Wechselstromrelais ist, wobei dem Relais (8) eine vorbestimmte minimale Nenn-Steuerspannung zum Schließen des geöffneten Relais (8) zugeordnet ist, wobei das Relais (8) zur Durchführung des Ladevorgangs mit einer Lade-Steuerspannung, welche größer ist als die minimale Nenn-Steuerspannung, betrieben wird, wobei der Abschaltvorgang zusätzlich vor dem Schaltauslösezeitpunkt ein Absenken der Steuerspannung des Relais (8) auf die minimale Nenn-Steuerspannung aufweist.

6. Verfahren nach einem der Ansprüche 1 - 4, wobei das Relais (8) ein Gleichstromrelais ist, wobei das Öffnen des Relais (8) als Reaktion auf den Empfang des Steuersignals (30) zur Schnellabschaltung ein Umpolen der Steuerspannung aufweist.

7. Verfahren nach einem der vorigen Ansprüche, wobei das Verfahren zusätzlich durch die Sicherheitsschaltung (2), als Reaktion auf den Empfang eines Steuersignals zum Laden des Elektrofahrzeugs (3) nach Durchführung der Schnellabschaltung, aufweist:
- Anlegen einer zweiten Testspannung an das Relais (8),
- Messen einer Spannungsantwort oder einer Stromstärkeantwort in einem Leitungsabschnitt, der zwischen dem Relais (8) und dem Ausgangsanschluss (5) angeordnet ist, in Reaktion auf das Anlegen der zweiten Testspannung,
- Überprüfen, ob ein Absolutwert der Spannungsantwort oder der Stromstärkeantwort einen vorbestimmten ersten Schwellwert beziehungsweise vorbestimmten zweiten Schwellwert überschreitet.

8. Verfahren nach einem der vorigen Ansprüche, wobei der Abschaltvorgang zusätzlich durch die Sicherheitsschaltung (2) aufweist:
- wenn die zum gewünschten Schaltzeitpunkt gemessene Spannung oder Stromstärke des Ladestroms um mehr als einen vorbestimmten dritten Schwellwert beziehungsweise vierten Schwellwert von einem bei der Bestimmung des gewünschten Schaltzeitpunkts für den gewünschten Schaltzeitpunkt erwarteten Wert der Spannung beziehungsweise der Stromstärke des Ladestroms abweicht, Erhöhen eines Zählwerts um eins,
- wenn der Zählwert einen vorbestimmten Zähl-Grenzwert erreicht oder überschreitet, Ausgeben einer Meldung, wobei die Meldung eine Empfehlung zum Wechseln des Relais (8) aufweist,
wobei das Verfahren zusätzlich durch die Sicherheitsschaltung (2) aufweist:
- als Reaktion auf einen Wechsel des Relais (8), Zurücksetzen des Zählwerts auf null.

9. Verfahren nach einem der vorigen Ansprüche, wobei der Eingangsanschluss (4) und der Ausgangsanschluss (5) jeweils eine vorbestimmte Anzahl P von Außenleitern (11.4, 12.4, 13.4, 11.5, 12.5, 13.5) aufweisen, wobei das Relais (8) eines von P Relais (8, 8.2, 8.3) ist, wobei jedes der P Relais (8, 8.2, 8.3) jeweils einen entsprechenden der P Außenleiter (11.4, 12.4, 13.4) des Eingangsanschlusses (4) über einen entsprechenden Schaltkontakt des Schützes (7) mit einem entsprechenden der P Außenleiter (11.5, 12.5, 13.5) des Ausgangsanschlusses (5) schaltend verbindet, wobei das Verfahren durch die Sicherheitsschaltung (2) ein Durchführen des Testvorgangs und des Abschaltvorgangs für jedes der P Relais (8, 8.2, 8.3) unabhängig von allen anderen der P Relais (8, 8.2, 8.3) aufweist.

10. Verfahren nach Anspruch 9, wobei der Eingangsanschluss (4) und der Ausgangsanschluss (5) zusätzlich jeweils einen Neutralleiter (10.4, 10.5) aufweisen, wobei ein weiteres Relais (8) den Neutralleiter (10.4) des Eingangsanschlusses (4) über einen entsprechenden Schaltkontakt des Schützes (7) mit dem Neutralleiter (10.5) des Ausgangsanschlusses (5) schaltend verbindet, wobei ein gewünschter Schaltzeitpunkt für das weitere Relais (8) auf einen spätesten der gewünschten Schaltzeitpunkte der P Relais (8, 8.2, 8.3) gesetzt wird.

11. Verfahren nach einem der vorigen Ansprüche, wobei der gewünschte Schaltzeitpunkt derart bestimmt wird, dass die verbleibende Zeit bis zum gewünschten Schaltzeitpunkt kürzer als eine Periodendauer des Ladestroms ist.

12. Verfahren nach einem der vorigen Ansprüche, wobei dem Relais (8) eine positive Lichtbogen-Schwellspannung (52) und/oder eine positive Lichtbogen-Schwellstromstärke (51) zugeordnet sind, wobei beim Öffnen des Relais (8) ein Lichtbogen entsteht, falls der Absolutwert der Stromstärke des Ladestroms größer oder gleich der Lichtbogen-Schwellstromstärke ist und / oder falls der Absolutwert der Spannung des Ladestroms größer oder gleich der Lichtbogen-Schwellspannung ist, wobei die Bestimmung des gewünschten Schaltzeitpunkts derart erfolgt, dass der gewünschte Schaltzeitpunkt innerhalb eines Stromstärke-Zeitfensters (61) liegt, in welchem die Stromstärke des Ladestroms kleiner oder gleich der Lichtbogen-Schwellstromstärke (51) ist, und / oder dass der gewünschte Schaltzeitpunkt innerhalb eines Spannungs-Zeitfensters (62) liegt, in welchem die Spannung des Ladestroms kleiner oder gleich der Lichtbogen-Schwellspannung (52) ist.

13. Verfahren nach Anspruch 12, wobei die Bestimmung des gewünschten Schaltzeitpunkts derart erfolgt, dass der gewünschte Schaltzeitpunkt innerhalb, vorzugweise am Beginn des Größten der Zeitfenster des Stromstärke-Zeitfensters (61) und des Spannungs-Zeitfensters (62) liegt,.

14. Verfahren nach Anspruch 12 oder 13, wobei die Bestimmung des gewünschten Schaltzeitpunkts so erfolgt, dass, falls ein Streumaß der aktuellen Schaltzeit und der mindestens einen historischen Schaltzeit einen vorbestimmten Streu-Grenzwert überschreitet, der gewünschte Schaltzeitpunkt innerhalb des Spannungs-Zeitfensters (62) liegt, und andernfalls, dass der gewünschte Schaltzeitpunkt innerhalb des Stromstärke-Zeitfensters (61) liegt.

15. Verfahren nach Anspruch 12 oder 13, wobei die Bestimmung des gewünschten Schaltzeitpunkts derart erfolgt, dass, falls eine Überlappung zwischen dem Stromstärke-Zeitfenster (61) und dem Spannungs-Zeitfenster (62) gegeben ist, der gewünschte Schaltzeitpunkt zu Beginn des durch das Spannungs-Zeitfenster (62) und das Stromstärke-Zeitfenster (61) gemeinsam definierten Zeitfensters liegt.

16. Computerprogrammprodukt mit von einem oder mehreren Prozessoren ausführbaren Instruktionen, wobei die Ausführung der Instruktionen die Prozessoren zur Durchführung des Verfahrens gemäß einem der vorigen Ansprüche veranlasst.

17. System zum Laden eines Elektrofahrzeugs (3) an einem Ladepunkt (1), wobei das System eine Sicherheitsschaltung (2) aufweist, wobei die Sicherheitsschaltung (2) aufweist:
- einen versorgungsnetzseitigen Eingangsanschluss (4) und einen elektrofahrzeugseitigen Ausgangsanschluss (5),
- ein Schütz (7) und ein Relais (8), wobei das Relais (8) mit dem Ausgangsanschluss (5) verbunden ist und über einen Schaltkontakt des Schützes (7) mit dem Eingangsanschluss (4) verbunden ist, wobei das Relais (8) im Vergleich zum Schütz (7) eine kürzere Nennschaltzeit aufweist
- eine Spannungsquelle (21), ein Messgerät (23) und ein Steuergerät (24),
wobei die Sicherheitsschaltung (2) ausgebildet ist zum:
- als Reaktion auf einen Empfang eines Steuersignals zum Laden des Elektrofahrzeugs (3) bei geöffnetem Schaltkontakt des Schützes (7), Durchführen eines Testvorgangs und eines Ladevorgangs, wobei der Testvorgang aufweist:
- Anlegen einer ersten Testspannung an das geöffnete oder geschlossene Relais (8),
- Auslösen eines Schließens oder Öffnens des Relais (8) bei angelegter erster Testspannung,
- während des Schließens oder Öffnens des Relais (8), Messen der durch das Relais (8) geschalteten ersten Testspannung oder einer Stromstärke eines aufgrund der ersten Testspannung durch das Relais (8) fließenden ersten Teststroms,
- Ermitteln einer aktuellen Schaltzeit des Relais (8) durch Auswertung der ersten Testspannung oder der Stromstärke des ersten Teststroms,
wobei der Ladevorgang aufweist:
- falls das Relais (8) bei der Messung der Stromstärke des ersten Teststroms geöffnet wurde, Auslösen eines Schließens des Relais (8),
- nach dem Schließen des Relais (8), Laden des Elektrofahrzeugs (3) mit einem Ladestrom durch Auslösen eines Schließens des Schaltkontaktes des Schützes (7),
- während des Ladevorgangs, Messen eines zeitlichen Verlaufs der Spannung und / oder der Stromstärke des Ladestroms;
- als Reaktion auf einen Empfang eines Steuersignals zur Schnellabschaltung des Ladevorgangs, Durchführen eines Abschaltvorgangs umfassend:
- basierend auf dem gemessenen zeitlichen Verlauf der Stromstärke und / oder der Spannung des Ladestroms, Bestimmen eines gewünschten Schaltzeitpunkts des Relais (8),
- Auslösen eines Öffnens des Relais (8) zu einem Schaltauslösezeitpunkt, wobei zum Schaltauslösezeitpunkt die verbleibende Zeit bis zum gewünschten Schaltzeitpunkt einem auf der aktuellen Schaltzeit basierenden Vorschaltintervall entspricht,
- Auslösen eines Öffnens des Schaltkontakts.

## Claims

1. A method for charging an electric vehicle (3) at a charging point (1) using a safety circuit (2), wherein the safety circuit (2) comprises:
- an input connection (4) on the supply network side and an output connection (5) on the electric vehicle side,
- a contactor (7) and a relay (8), wherein the relay (8) is connected to the output connection (5) and is connected to the input connection (4) via a switching contact of the contactor (7), wherein the relay (8) has a shorter rated switching time than the contactor (7),
- a voltage source (21), a measuring device (23) and a control unit (24),
wherein the method through the safety circuit (2) comprises:
- in response to receiving a control signal (26) for charging the electric vehicle (3), when the switching contact of the contactor (7) is open, performing a testing process and a charging process, wherein the testing process comprises:
- applying a first test voltage to the opened or closed relay (8),
- triggering the closing or opening of the relay (8) when the first test voltage is applied,
- during the closing or opening of the relay (8), measuring a first test voltage switched through the relay (8) or a current strength of a first test current flowing through the relay (8) due to the first test voltage,
- determining a current switching time of the relay (8) by evaluating the first test voltage or the current strength of the first test current,
wherein the charging process includes:
- if the relay (8) was opened during the measurement of the current strength of the first test current, triggering a closing of the relay (8),
- after closing the relay (8), charging the electric vehicle (3) with a charging current by triggering a closing of the switching contact of the contactor (7),
- during the charging process, measuring a time characteristic of the voltage and/or the current strength of the charging current;
- in response to receiving a control signal (30) for the rapid switch-off of the charging process, performing a switch-off process comprising:
- determining a desired switching time point of the relay (8) based on the measured time characteristic of the current strength and/or the voltage of the charging current,
- triggering an opening of the relay (8) at a switching triggering time point, wherein at the switching triggering time point the remaining time until the desired switching time point corresponds to a preswitching interval based on the current switching time,
- triggering an opening of the switching contact.

2. The method according to claim 1, wherein the duration of the preswitching interval corresponds with the current switching time.

3. The method according to any one of the preceding claims, wherein the testing process additionally comprises storage of the determined current switching time in a non-volatile memory (34) by the safety circuit (2), wherein the charging process additionally comprises determining the preswitching interval by the safety circuit (2) based on the current switching time and at least one further historic switching time of the relay (8) stored in the non-volatile memory (34).

4. The method according to claim 3, wherein the duration of the pre-switching interval is based on an average value of the current switching time and one or more of the historic switching times, resulting from a predetermined number of recent repetitions of the determination of the current switching time.

5. The method according to any one of the preceding claims, wherein the relay (8) is an alternating current relay, wherein a predetermined minimum nominal control voltage for closing the opened relay (8) is assigned to the relay (8), wherein the relay (8) is operated with a charging control voltage, which is greater than the minimum nominal control voltage, in order to carry out the charging process, wherein the switch-of process additionally comprises lowering the control voltage of the relay (8) to the minimum nominal control voltage before the switch triggering time point.

6. The method according to any one of claims 1 to 4, wherein the relay (8) is a direct current relay, wherein the opening of the relay (8) comprises a reversal of the polarity of the control voltage in response to receiving the control signal (30) for rapid switch-off.

7. The method according to any one of the preceding claims, wherein the method additionally comprises through the safety circuit (2), in response to receiving a control signal for charging the electric vehicle (3) after performing the rapid switch-off:
- applying a second test voltage to the relay (8),
- measuring a voltage response or a current strength response in a line portion arranged between the relay (8) and the output connection (5) in response to the application of the second test voltage,
- checking whether an absolute value of the voltage response or the current strength response exceeds a predetermined first threshold or a predetermined second threshold.

8. The method according to any one of the preceding claims, wherein the switch-off process additionally comprises through the safety circuit (2):
- if the voltage or current strength of the charging current measured at the desired switching time point deviates by more than a predetermined third threshold or fourth threshold from a value of the voltage or current strength of the charging current strength of the charging current expected when determining the desired switching time point for the desired switching time point, increasing a count value by one,
- when the count value reaches or exceeds a predetermined count limit value, outputting a message, wherein the message includes a recommendation to change the relay (8),
wherein the method additionally comprises through the safety circuit (2):
- as a reaction to a change of the relay (8), resetting the count value to zero.

9. The method according to any one of the preceding claims, wherein the input connection (4) and the output connection (5) each have a predetermined number P of outer conductors (11.4, 12.4, 13.4, 11.5, 12.5, 13.5), wherein the relay (8) is one of P relays (8, 8.2, 8.3), wherein each of the P relays (8, 8.2, 8.3) connects by switching a corresponding P outer conductor (11.4, 12.4, 13.4) of the input connection (4) via a corresponding switching contact of the contactor (7) to a corresponding P outer conductor (11.5, 12.5, 13.5) of the output connection (5), wherein the method comprises performing the testing process and the switch-off process for each of the P relays (8, 8.2, 8.3) independently of all other P relays (8, 8.2, 8.3) through the safety circuit (2).

10. The method according to claim 9, wherein the input connection (4) and the output connection (5) additionally each comprise a neutral conductor (10.4, 10.5), wherein a further relay (8) connects the neutral conductor (10.4) of the input connection (4) via a corresponding switching contact of the contactor (7) to the neutral conductor (10.5) of the output connection (5), wherein a desired switching time point for the further relay (8) is set to a latest one of the desired switching time points of the P relay (8, 8.2, 8.3).

11. The method according to any one of the preceding claims, wherein the desired switching time point is determined such that the remaining time until the desired switching time point is shorter than a period duration of the charging current.

12. The method according to any one of the preceding claims, wherein a positive arc threshold voltage (52) and/or a positive arc threshold current strength (51) are assigned to the relay (8), wherein an arc is formed on opening the relay (8) if the absolute value of the current strength of the charging current is greater than or equal to the arc threshold current strength and/or if the absolute value of the voltage of the charging current is greater than or equal to the arc threshold voltage, wherein the desired switching time point is determined such that the desired switching time point is within a current strength time window (61), in which the current strength of the charging current is less than or equal to the arc threshold current strength (51), and/or the desired switching time point is within a voltage time window (62) in which the voltage of the charging current is less than or equal to the arc threshold voltage (52).

13. The method according to claim 12, wherein the desired switching time point is determined such that the desired switching time point is within, preferably at the beginning of the largest of the time windows of the current strength-time window (61) and the voltage time window (62).

14. The method according to claim 12 or 13, wherein the desired switching time point is determined such that, if a measure of variation of the current switching time and the at least one historic switching time exceeds a predetermined variation limit, the desired switching time point is within the voltage time window (62), and otherwise the desired switching time point is within the current strength time window (61).

15. The method according to claim 12 or 13, wherein the desired switching time point is determined such that, if there is an overlap between the current strength time window (61) and the voltage time window (62), the desired switching time point is at the beginning of the time window jointly defined by the voltage time window (62) and the current strength time window (61).

16. A computer program product comprising instructions which can be executed by one or more processors, wherein the execution of the instructions causes the processors to perform the method according to any one of the preceding claims.

17. A system for charging an electric vehicle (3) at a charging point (1), wherein the system comprises a safety circuit (2), wherein the safety circuit (2) comprises:
- an input connection (4) on the supply network side and an output connection (5) on the electric vehicle side,
- a contactor (7) and a relay (8), wherein the relay (8) is connected to the output connection (5) and is connected to the input connection (4) via a switching contact of the contactor (7), wherein the relay (8) has a shorter rated switching time than the contactor (7),
- a voltage source (21), a measuring device (23) and a control unit (24),
wherein the safety circuit (2) is configured:
- in response to receiving a control signal for charging the electric vehicle (3), when the switching contact of the contactor (7) is open, to perform a testing process and a charging process, wherein the testing process comprises:
- to apply a first test voltage to the opened or closed relay (8),
- to trigger the closing or opening of the relay (8) when the first test voltage is applied,
- during the closing or opening of the relay (8), to measure the first test voltage switched through the relay (8) or a current strength of a first test current flowing through the relay (8) due to the first test voltage,
- to determine a current switching time of the relay (8) by evaluating the first test voltage or the current strength of the first test current,
wherein the charging process includes:
- if the relay (8) was opened during the measurement of the current strength of the first test current, triggering a closing of the relay (8),
- after closing the relay (8), charging the electric vehicle (3) with a charging current by triggering a closing of the switching contact of the contactor (7),
- during the charging process, measuring a time characteristic of the voltage and/or the current strength of the charging current;
- in response to receiving a control signal for the rapid switch-off of the charging process, performing a switch-off process comprising:
- determining a desired switching time point of the relay (8) based on the measured time characteristic of the current strength and/or the voltage of the charging current,
- triggering an opening of the relay (8) at a switching triggering time point, wherein at the switching triggering time point the remaining time until the desired switching time point corresponds to a preswitching interval based on the current switching time,
- triggering an opening of the switching contact.

## Revendications

1. Procédé de charge d'un véhicule électrique (3) sur un point de recharge (1) moyennant l'emploi d'un circuit de sécurité (2), dans lequel le circuit de sécurité (2) présente :
- une connexion d'entrée (4) coté réseau d'alimentation et une connexion de sortie (5) coté véhicule électrique,
- un contacteur (7) et un relais (8), où le relais (8) est relié avec la connexion de sortie (5) et est relié avec la connexion d'entrée (4) par le biais d'un contact de commutation du contacteur (7), où le relais (8), comparativement au contacteur (7), présente un temps de commutation nominal plus court,
- une source de tension (21), un dispositif de mesure (23) et un dispositif de commande (24),
le procédé présentant, par le circuit de sécurité (2) :
- en réaction à une réception d'un signal de commande (26) pour la charge du véhicule électrique (3), pour un contact de commutation du contact (7) ouvert, l'exécution d'un processus de test et d'un processus de charge, où le processus de test présente :
- l'application d'une première tension de test sur le relais (8) ouvert ou fermé,
- le déclenchement d'une fermeture ou d'une ouverture du relais (8) pour une première tension de test appliquée,
- pendant la fermeture ou l'ouverture du relais (8), la mesure d'une première tension de test commutée par le relais (8) ou d'une intensité de courant d'un premier courant de test passant à travers le relais (8) en raison de la première tension de test,
- la détermination d'un temps de commutation actuel du relais (8) par l'évaluation de la première tension de test ou de l'intensité de courant du premier courant de test,
dans lequel le processus de charge présente :
- dans le cas où le relais (8) a été ouvert lors de la mesure de l'intensité de courant du premier courant de test, le déclenchement d'une fermeture du relais (8),
- après la fermeture du relais (8), la charge du véhicule électrique (3) avec un courant de charge par le déclenchement d'une fermeture du contact de commutation du contacteur (7),
- pendant le processus de charge, la mesure d'une évolution dans le temps de la tension, et/ou de l'intensité du courant du courant de charge ;
- en réaction à une réception d'un signal de commande (30) pour l'interruption rapide du processus de charge, l'exécution d'un processus de déconnexion comprenant :
- en se basant sur l'évolution dans le temps mesurée de l'intensité du courant et/ou de la tension du courant de charge, la détermination d'un temps de commutation souhaité du relais (8),
- le déclenchement d'une ouverture du relais (8) à un temps de déclenchement de commutation, où, le temps restant jusqu'au temps de déclenchement de commutation jusqu'au temps de commutation souhaité correspond à un intervalle de pré-commutation se basant sur le temps de commutation actuel,
- le déclenchement d'une ouverture du contact de commutation.

2. Procédé selon la revendication 1, dans lequel la durée de l'intervalle de pré-commutation correspond au temps de commutation actuel.

3. Procédé selon l'une des revendications précédentes, dans lequel le processus de test présente en outre un enregistrement du temps de commutation actuel déterminé dans une mémoire (34) non volatile par le circuit de sécurité (2), où le processus de charge présente en outre une détermination de l'intervalle de pré-commutation par le circuit de sécurité (2) en se basant sur le temps de commutation actuel ainsi que sur au moins un autre temps de commutation historique du relais (8) enregistré dans la mémoire (34) non volatile.

4. Procédé selon la revendication 3, dans lequel la durée de l'intervalle de pré-commutation se base sur une valeur moyenne du temps de commutation actuel et un ou plusieurs temps de commutation historiques, lesquels résultent d'un nombre prédéterminé de répétitions récentes de la détermination du temps de commutation actuel.

5. Procédé selon l'une des revendications précédentes, dans lequel le relais (8) est un relais de courant alternatif, où une tension de commande nominale minimale prédéterminée est associée au relais (8) pour la fermeture du relais (8) ouvert, où le relais (8) est activé pour l'exécution du processus de charge avec une tension de commande de charge laquelle est supérieure à la tension de commande nominale minimale, où le processus d'arrêt, de manière complémentaire au temps de déclenchement de commutation d'arrêt, présente une diminution de la tension de commande du relais (8) jusqu'à la tension de commande nominale minimale.

6. Procédé selon l'une des revendications 1 à 4, dans lequel le relais (8) est un relais de courant continu, où l'ouverture du relais (8) présente une repolarisation de la tension de commande en réaction à la réception du signal de commande (30) pour une commutation d'arrêt rapide.

7. Procédé selon l'une des revendications précédentes, présentant en outre, par le circuit de sécurité (2), en réaction à la réception d'un signal de commande pour la charge du véhicule électrique (3) après l'exécution de la commutation d'arrêt rapide :
- l'application d'une deuxième tension de test au relais (8),
- la mesure d'une tension de réponse ou d'une intensité de courant de réponse dans un segment de conduite qui est disposé entre le relais (8) et la connexion de sortie (5), en réaction à l'application de la deuxième tension de test,
- la vérification si une valeur absolue de la tension de réponse ou de l'intensité de courant de réponse dépasse une première valeur de seuil prédéfinie, respectivement, une deuxième valeur de seuil prédéfinie.

8. Procédé selon l'une des revendications précédentes, dans lequel le processus de commutation d'arrêt présente en outre, par le circuit de sécurité (2) :
- lorsque la tension ou l'intensité de courant du courant de charge mesurée au temps de commutation souhaité dévie de plus d'une troisième valeur de seuil prédéfinie, respectivement d'une quatrième valeur de seuil prédéfinie, d'une valeur attendue pour le temps de commutation souhaité lors de la détermination du temps de commutation souhaité de la tension, respectivement de l'intensité de courant du courant de charge, il y a une augmentation de la valeur de comptage de un,
- lorsque la valeur de comptage atteint ou dépasse une valeur limite de comptage prédéfinie, il y a émission d'un avertissement, où l'avertissement donne un conseil pour le changement du relais (8),
le procédé présentant en outre, par le circuit de sécurité (2) :
- en réaction à un changement de relais (8), le retour de la valeur de comptage sur zéro.

9. Procédé selon l'une des revendications précédentes, dans lequel la connexion d'entrée (4) et la connexion de sortie (5) présentent un nombre P prédéfini de conducteurs externes (11.4, 12.4, 13.4, 11.5, 12.5, 13.5), où le relais (8) est l'un des P relais (8, 8.2, 8.3), où chacun des P relais (8, 8.2, 8.3) relie par commutation respectivement un des P conducteurs externes (11.4, 12.4, 13.4) correspondants de la connexion d'entrée (4) par le biais d'un contact de commutation correspondant du contact (7) avec un des P conducteurs externes (11.5, 12.5, 13.5) correspondants de la connexion de sortie (5), le procédé présentant, par le circuit de sécurité (2), l'exécution du processus de test et du processus de commutation d'arrêt pour chacun des P relais (8, 8.2, 8.3) de manière indépendante par rapport à tous les autres des P relais (8,8.2, 8.3).

10. Procédé selon la revendication 9, dans lequel la connexion d'entrée (4) et la connexion de sortie (5) présentent en outre respectivement un conducteur neutre (10.4, 10.5), où un nouveau relais (8) relie par commutation le conducteur neutre (10.4) de la connexion d'entrée (4) par le biais d'un contact de commutation correspondant du contact (7) avec le conducteur neutre (10.5) de la connexion de sortie (5), où un temps de commutation souhaité pour le nouveau relais (8) est réglé sur un des temps de commutation souhaité plus loin parmi les P relais (8, 8.2, 8.3).

11. Procédé selon l'une des revendications précédentes, dans lequel le temps de commutation souhaité est déterminé de telle manière que le temps restant jusqu'au temps de commutation souhaité est plus court qu'une durée de période du courant de charge.

12. Procédé selon l'une des revendications précédentes, dans lequel une tension de seuil d'arc positive (52) et/ou une intensité de courant de seuil d'arc positive (51) sont associées au relais (8), où, lors de l'ouverture du relais (8), il se crée un arc, dans le cas où la valeur absolue de l'intensité de courant du courant de charge est supérieure ou égale à l'intensité de courant de seuil d'arc, et/ou dans le cas où la valeur absolue de la tension du courant de charge est supérieure ou égale à la tension de seuil d'arc, où la détermination du temps de commutation souhaité a lieu de telle manière que le temps de commutation souhaité se situe à l'intérieur d'une fenêtre temporelle d'intensité de courant (61) dans laquelle l'intensité de courant du courant de charge est inférieure ou égale à l'intensité de courant de seuil de l'arc (51), et/ou que le temps de commutation souhaité se situe à l'intérieur d'une fenêtre temporelle de tension (62) dans laquelle la tension du courant de charge est inférieure ou égale à la tension de seuil de l'arc (52).

13. Procédé selon la revendication 12, dans lequel la détermination du temps de commutation souhaité a lieu de telle manière que le temps de commutation souhaité se situe à l'intérieur, de préférence, au début de la plus grande des fenêtres temporelles parmi la fenêtre temporelle d'intensité de courant (61) et la fenêtre temporelle de tension (62).

14. Procédé selon la revendication 12 ou la revendication 13, dans lequel la détermination du temps de commutation souhaité a lieu de telle manière qu'une mesure de variabilité du temps de commutation actuel et de l'au moins un temps de commutation historique dépasse une valeur de seuil de variabilité prédéfinie, le temps de commutation souhaité se situe à l'intérieur de la fenêtre temporelle de tension (62), et autrement, que le temps de commutation souhaité se situe à l'intérieur de la fenêtre temporelle d'intensité de courant (61).

15. Procédé selon la revendication 12 ou la revendication 13, dans lequel la détermination du temps de commutation souhaité a lieu de telle manière qu'une superposition entre la fenêtre temporelle d'intensité de courant (61) et la fenêtre temporelle de tension (62) est produite, le temps de commutation souhaité se situe au début de la fenêtre temporelle définie par la fenêtre temporelle de tension (62) et la fenêtre temporelle d'intensité de courant (61) ensemble.

16. Produit programme avec des instructions exécutables par un ou plusieurs processeurs, où l'exécution des instructions fait en sorte que les processeurs exécutent le procédé selon l'une des revendications précédentes.

17. Système de charge d'un véhicule électrique (3) sur un point de recharge (1) où le système présente un circuit de sécurité (2), dans lequel le circuit de sécurité (2) présente :
- une connexion d'entrée (4) coté réseau d'alimentation et une connexion de sortie (5) coté véhicule électrique,
- un contacteur (7) et un relais (8), où le relais (8) est relié avec la connexion de sortie (5) et est relié avec la connexion d'entrée (4) par le biais d'un contact de communication du contacteur (7), où le relais (8), comparativement au contacteur (7), présente un temps de commutation nominal plus court,
- une source de tension (21), un dispositif de mesure (23) et un dispositif de commande (24),
dans lequel le circuit de sécurité (2) est conçu pour :
- en réaction à une réception d'un signal de commande pour la charge du véhicule électrique (3) pour un contact de commutation du contacteur (7) ouvert, l'exécution d'un processus de test et d'un processus de charge, où le processus de test présente :
- l'application d'une première tension de test sur le relais (8) ouvert ou fermé,
- le déclenchement d'une fermeture ou d'une ouverture du relais (8) pour une première tension de test appliquée,
- pendant la fermeture ou l'ouverture du relais (8), la mesure d'une première tension de test commutée par le relais (8) ou d'une intensité de courant d'un premier courant de test passant à travers le relais (8) en raison de la première tension de test,
- la détermination d'un temps de commutation actuel du relais (8) par l'évaluation de la première tension de test ou de l'intensité de courant du premier courant de test,
dans lequel le processus de charge présente :
- dans le cas où le relais (8) a été ouvert lors de la mesure de l'intensité de courant du premier courant de test, le déclenchement d'une fermeture du relais (8),
- après la fermeture du relais (8), la charge du véhicule électrique (3) avec un courant de charge par le déclenchement d'une fermeture du contact de commutation du contacteur (7),
- pendant le processus de charge, la mesure d'une évolution dans le temps de la tension, et/ou de l'intensité du courant du courant de charge ;
- en réaction à une réception d'un signal de commande pour l'interruption rapide du processus de charge, l'exécution d'un processus de déconnexion comprenant :
- en se basant sur l'évolution dans le temps mesurée de l'intensité du courant et/ou de la tension du courant de charge, la détermination d'un temps de commutation souhaité du relais (8),
- le déclenchement d'une ouverture du relais (8) à un temps de commutation d'arrêt, où le temps restant jusqu'au temps de déclenchement de commutation jusqu'au temps de commutation souhaité correspond un intervalle de pré-commutation se basant sur le temps de commutation actuel,
- le déclenchement d'une ouverture du contact de commutation.
